# EUROPEAN PATENT APPLICATION

(11) **EP 4 766 085 A1**
(43) Date of publication of application: **24.06.2026**
(21) Application number: 25206474.6
(22) Date of filing: 02.10.2025
(51) Int. Cl.: H10D 62/10, H10D 30/66, H10D 84/00, H10D 30/01

(54) **SEMICONDUCTOR DEVICE**

(30) Priority: 19.12.2024 KR 20240191830; 04.02.2025 KR 20250014032
(71) Applicant: Samsung Electronics Co., Ltd., Suwon-si, Gyeonggi-do 16677 (KR)
(72) Inventor: CHOI, Minwook, Suwon-si (KR); OH, Sewoong, Suwon-si (KR); WOO, Sangsu, Suwon-si (KR); KIL, Taehyeon, Suwon-si (KR); KIM, Taehun, Suwon-si (KR); PARK, Young Hwan, Suwon-si (KR); CHUNG, Yonghyuk, Suwon-si (KR); HONG, Sungtaek, Suwon-si (KR)
(74) Representative: Marks & Clerk LLP

(57) **Abstract**

The present disclosure relates to a semiconductor device and a method for manufacturing the same. According to an embodiment, the semiconductor device includes a substrate including a first surface and a second surface opposing each other; an epitaxial layer positioned on the first surface of the substrate and including a gate trench, the epitaxial layer having a first conductivity type; a gate electrode positioned within the gate trench; a gate insulating layer positioned between the epitaxial layer and the gate electrode; a source electrode positioned on the epitaxial layer; a well region positioned on one side of the gate electrode, between the epitaxial layer and the source electrode, and the well region having a second conductivity type different from the first conductivity type; a first deep well region positioned on the other side of the gate electrode, between the epitaxial layer and the source electrode, and the first deep well region having the second conductivity type; a shield pattern positioned between the epitaxial layer and the first deep well region, and the shield pattern overlapping the gate electrode; and a drain electrode positioned on the second surface of the substrate; wherein the lower surface of the shield pattern includes a convex curved surface toward the drain electrode.

## Description

### BACKGROUND

### 1. Field

The present disclosure relates to a semiconductor device.

### 2. Description of the Related Art

In modern society, semiconductor devices are closely related to our daily lives. In particular, the importance of power semiconductor devices used in various fields such as transportation such as electric vehicles, railways, and electric trams, renewable energy systems such as solar power generation and wind power generation, and mobile devices is gradually increasing. Power semiconductor devices are semiconductor devices used to handle high voltage or high current, and perform functions such as power conversion and control in large power systems or high-power electronic devices. Power semiconductor devices have the ability to handle high power and durability, allowing them to handle large amounts of current and withstand high voltages. For example, power semiconductor devices may handle voltages from hundreds to thousands of volts and currents from tens to thousands of amperes. Power semiconductor devices may improve the efficiency of electrical energy by minimizing power loss. Additionally, power semiconductor devices may operate stably even in environments such as high temperatures.

These power semiconductor devices may be classified by material, for example, there are SiC power semiconductor devices and GaN power semiconductor devices. By manufacturing power semiconductor devices using SiC or GaN instead of existing silicon wafers (Si wafers), the shortcomings of silicon, which has unstable characteristics at high temperatures, may be complemented. SiC power semiconductor devices are resistant to high temperatures and have low power loss, making them suitable for electric vehicles and renewable energy systems. GaN power semiconductor devices are expensive but efficient in terms of speed, making them suitable for fast charging of mobile devices.

### SUMMARY

Aspects of the disclosed embodiments provide a semiconductor device with stable electric characteristics and improved reliability.

In an embodiment, a semiconductor device includes a substrate including a first surface and a second surface opposing each other; an epitaxial layer positioned on the first surface of the substrate and including a gate trench, the epitaxial layer having a first conductivity type; a gate electrode positioned within the gate trench; a gate insulating layer positioned between the epitaxial layer and the gate electrode; a source electrode positioned on the epitaxial layer; a well region positioned on a first side of the gate electrode, between the epitaxial layer and the source electrode, the well region having a second conductivity type different from the first conductivity type; a first deep well region positioned on a second side of the gate electrode opposite the first side, between the epitaxial layer and the source electrode, and the first deep well region having the second conductivity type and extending below the source electrode a greater distance than the well region; a shield pattern positioned between the epitaxial layer and the first deep well region, and the shield pattern overlapping the gate electrode; and a drain electrode positioned on the second surface of the substrate; wherein the lower surface of the shield pattern includes a convex curved surface that is convex toward the drain electrode.

According to an embodiment, a semiconductor device includes a substrate including a first surface and a second surface opposing each other; an epitaxial layer positioned on the first surface of the substrate, including a gate trench, having a first conductivity type; a gate electrode positioned within the gate trench; a gate insulating layer positioned between the epitaxial layer and the gate electrode; a source electrode positioned on the epitaxial layer; a well region positioned on a first side of the gate electrode, between the epitaxial layer and the source electrode, the well region having a second conductivity type, different from the first conductivity type; a first deep well region positioned on a second side of the gate electrode opposite the first side, and between the epitaxial layer and the source electrode, the first deep well region having the second conductivity type; a second deep well region positioned between the epitaxial layer and the source electrode, located on a first side of the well region, the second deep well region having the second conductivity type; a first doped layer positioned between the well region and the source electrode, the first doped layer having the first conductivity type; a second doped layer positioned between the first deep well region and the source electrode, the second doped layer having the second conductivity type; a third doped layer positioned between the second deep well region and the source electrode; a shield pattern positioned between the epitaxial layer and the first deep well region, the shield pattern having the second conductivity type; and a drain electrode positioned on the second surface of the substrate; wherein a width of the shield pattern is greater than or equal to a width of the first deep well region, and the shield pattern has a doping concentration greater than or equal to doping concentration of the first deep well region.

According to an embodiment, a semiconductor device includes a substrate including an active area where a plurality of cells are positioned and a peripheral area surrounding at least a portion of the active area; and a gate frame positioned in the peripheral area, including a first portion and a second portion, the first portion and the second portion extending in a first direction and arranged spaced apart in a second direction intersecting the first direction; the plurality of cells are positioned between the first portion and the second portion of the gate frame; wherein each of the plurality of cells includes: an epitaxial layer including a gate trench positioned on a first surface of the substrate and extending in the second direction, the epitaxial layer having a first conductivity type; a gate electrode positioned within the gate trench and electrically connected to the gate frame; a gate insulating layer positioned between the epitaxial layer and the gate electrode; a source electrode positioned on the epitaxial layer; a well region positioned on a first side of the gate electrode along the first direction, and positioned between the epitaxial layer and the source electrode, the well region having a second conductivity type different from the first conductivity type; a first deep well region positioned on a second side of the gate electrode opposite the first side along the first direction, and positioned between the epitaxial layer and the source electrode, the first deep well region having the second conductivity type; a shield pattern positioned between the epitaxial layer and the first deep well region, extending in the second direction, and overlapping the gate electrode; and a drain electrode positioned on a second surface of the substrate opposite the first surface, wherein a lower surface of the shield pattern includes a convex curved surface that is convex toward the drain electrode.

According to an embodiment, a method for manufacturing a semiconductor device comprises the steps of: forming an epitaxial layer having a first conductivity type on a first surface of a substrate; forming a second preliminary shield layer having a second conductivity type different from the first conductivity type by using a channel ion implantation process within the epitaxial layer; forming a first preliminary shield layer overlapping the second preliminary shield layer and having the second conductivity type within the epitaxial layer; forming a first deep well region overlapping the first preliminary shield layer and having the second conductivity type within the epitaxial layer; forming a preliminary well region having the second conductivity type on at least one side of the first deep well region; forming a gate trench by patterning the preliminary well region and the first deep well region to form a well region; and forming a first shield layer and a second shield layer by patterning the first preliminary shield layer and the second preliminary shield layer, forming a gate insulating layer within the gate trench; forming a gate electrode filling the gate trench; forming a source electrode over the well region; and It includes a step of forming a drain electrode on a second surface opposite to the first surface.

The lower surface of the second shield layer may include a convex curved surface toward the first surface of the substrate.

The doping concentration of the first deep well region may be greater than the doping concentration of the well region.

The thickness along the vertical direction of the first deep well region may be greater than the thickness of the well region along the vertical direction.

The doping concentration of the second shield layer may be greater than or equal to the doping concentration of the first deep well region.

After forming the above-described preliminary well region, the method may further include forming a first doped layer having the first conductivity type within the above-described preliminary well region, and forming a second doped layer having the second conductivity type within the above-described first deep well region.

After forming the first deep well region, the method further includes forming a second deep well region having the second conductivity type within the epitaxial layer, wherein the thickness of the second deep well region may be greater than the thickness of the well region.

The second deep well region may be positioned spaced apart from the first deep well region.

The doping concentration of the second deep well region may be greater than the doping concentration of the well region.

The shield pattern may include a first shield layer positioned below the gate insulating layer and having the second conductivity type, and a second shield layer positioned below the first deep well region and having the second conductivity type, wherein a lower surface of the second shield layer may include a convex curved surface toward the drain electrode.

The first shield layer may protrude from the lower surface of the gate insulating layer toward the first surface of the substrate.

The width of the first shield layer is smaller than the width of the gate trench.

A portion of the first shield layer may overlap the epitaxial layer, and a remaining portion of the first shield layer may overlap the second shield layer.

The first shield layer may overlap the gate electrode and may not overlap the first deep well region.

The device further includes a dummy pattern positioned between the epitaxial layer and the gate insulating layer, wherein the dummy pattern may be positioned spaced apart from the first shield layer.

The dummy pattern may include the same material as the gate insulating layer.

According to embodiments, the reliability of semiconductor devices may be improved. At least some of the above and other features of the invention are set out in the claims.

### BRIEF DESCRIPTION OF THE DRAWINGS

FIG. 1 is a plan view showing a semiconductor device according to an embodiment.
FIG. 2 is a cross-sectional view taken along line A-A' of FIG.1.
FIG. 3 is an enlarged cross-sectional view of area S1 of FIG.2.
FIGS. 4 to 16 are cross-sectional views corresponding to area S1 of FIG. 2, showing semiconductor devices according to some embodiments.
FIG. 17 is a plan view illustrating a semiconductor device according to some embodiments.
FIGS. 18 to 30 are cross-sectional views corresponding to A-A' of FIG. 1, showing a method for manufacturing a semiconductor device according to an embodiment.
FIGS. 31 to 35 are cross-sectional views corresponding to A-A' of FIG. 1, showing a method for manufacturing a semiconductor device according to the embodiments of FIGS. 14 to 16.

### DETAILED DESCRIPTION

Hereinafter, various embodiments will be described in detail with reference to the attached drawings so that a person having ordinary skill in the art to which the present invention pertains may easily implement the invention. The present invention may be embodied in many different forms and is not limited to the embodiments described herein.

In order to clearly and succinctly explain the present invention, certain parts may be omitted, and the same reference numerals are used for identical or similar components throughout the specification.

In addition, the size and the thickness of each component shown in the drawings are arbitrarily shown for convenience of explanation, so the present invention is not necessarily limited to what is shown. To clearly represent the various layers and areas in the drawing, the thickness is enlarged as shown. And in the drawing, for convenience of explanation, the thickness of some layers and areas is exaggerated.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

Spatially relative terms, such as "beneath," "below," "lower," "above," "upper," "top," "bottom," "front," "rear," and the like, may be used herein for ease of description to describe positional relationships, such as illustrated in the figures, for example. It will be understood that the spatially relative terms encompass different orientations of the device in addition to the orientation depicted in the figures. These terms may refer to relative positions along a particular direction (e.g. a third direction, or vertical direction, discussed herein). The vertical direction may be a direction perpendicular to an upper surface of a substrate of the device. Various vertical levels may be defined along the vertical direction (e.g., as respective distances from the substrate in the vertical direction). A horizontal direction may be a direction parallel to the upper surface of the substrate of the device. Various directions (e.g. vertical direction, horizontal direction, etc.) may be defined relative to the structure of the devices described herein. It will be appreciated that these directions do not necessarily imply any particular orientation of the device in use.

Also these spatially relative terms such as "above" and "below" as used herein have their ordinary broad meanings-for example element A can be above element B even if when looking down on the two elements there is no overlap between them (just as something in the sky is generally above something on the ground, even if it is not directly above). The term "overlap" (or "overlapping", or like terms) in a particular direction, as may be used herein, is intended to broadly refer to a first element that intersects with at least a portion of a second element in the particular direction, but does not require that the first and second elements be completely aligned with one another; that is, components or layers described with reference to "overlap" in a particular direction may be at least partially obstructed by one another when viewed along a line extending in the particular direction.

Throughout the specification, when a component is described as "including" a particular element or group of elements, it is to be understood that the component is formed of only the element or the group of elements, or the element or group of elements may be combined with additional elements to form the component, unless the context indicates otherwise. The term "consisting of," on the other hand, indicates that a component is formed only of the element(s) listed.

It will be understood that, although the terms first, second, third etc. may be used herein to describe various elements, components, regions, layers and/or sections, these elements, components, regions, layers and/or sections should not be limited by these terms. Unless the context indicates otherwise, these terms are only used to distinguish one element, component, region, layer or section from another element, component, region, layer or section, for example as a naming convention. Thus, a first element, component, region, layer or section discussed below in one section of the specification could be termed a second element, component, region, layer or section in another section of the specification or in the claims without departing from the teachings of the present invention. In addition, in certain cases, even if a term is not described using "first," "second," etc., in the specification, it may still be referred to as "first" or "second" in a claim in order to distinguish different claimed elements from each other.

An item, layer, or portion of an item or layer described as extending "lengthwise" in a particular direction has a length in the particular direction and a width perpendicular to that direction, where the length is greater than the width.

Items described in the singular herein may be provided in plural, as can be seen, for example, in the drawings. Thus, the description of a single item that is provided in plural should be understood to be applicable to the remaining plurality of items unless context indicates otherwise.

Terms such as "about" or "approximately" may reflect amounts, sizes, orientations, or layouts that vary only in a small relative manner, and/or in a way that does not significantly alter the operation, functionality, or structure of certain elements. Values or ends of ranges that are quoted as "about" particular values, may be equal to those values, or may be within acceptable variations of the values that may occur, for example, due to manufacturing processes. For example, a range from "about 0.1 to about 1" may encompass a range of 0.1 to 1 and may also encompass a range such as a 0%-1% deviation around 0.1 and a 0% to 1% deviation around 1, or a particular value may deviate by up to plus or minus 1%, especially if such deviation maintains the same effect as the listed range.

Terms such as "same," "equal," "planar," or "coplanar," as used herein when referring to orientation, layout, location, shapes, sizes, compositions, amounts, or other measures do not necessarily mean an exactly identical orientation, layout, location, shape, size, composition, amount, or other measure, but are intended to encompass nearly identical orientation, layout, location, shapes, sizes, compositions, amounts, or other measures within typical variations that may occur resulting from conventional manufacturing processes. The term "substantially" may be used herein to emphasize this meaning, unless the context or other statements indicate otherwise. For example, items described as "substantially the same," "substantially equal," or "substantially planar," may be exactly the same, equal, or planar, or may be the same, equal, or planar within acceptable variations that may occur, for example, due to manufacturing processes.

Additionally, throughout the specification, a "plan view" refers to a target portion being viewed from above, and a "cross sectional view" or a "cross section" refers to a target portion being viewed from the side in a cross-section cut vertically.

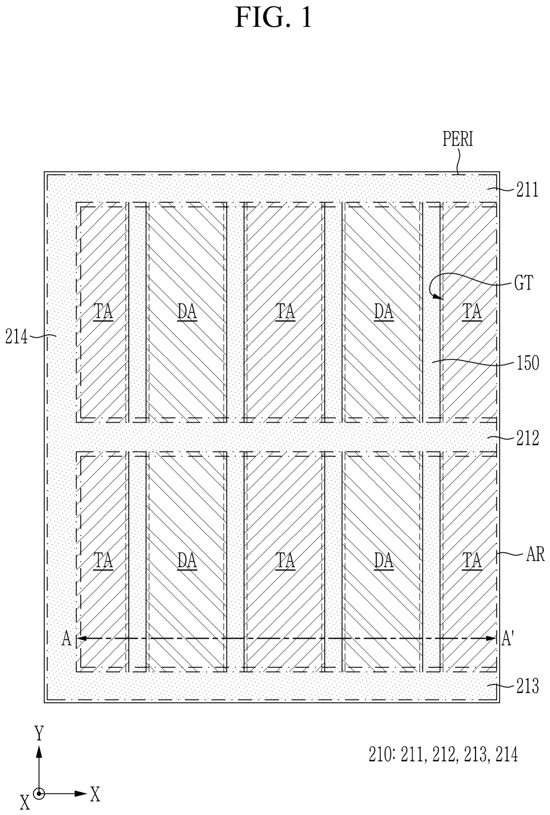

Hereinafter, a semiconductor device according to an embodiment will be described with reference to FIGS. 1-3.

FIG. 1 is a plan view showing a semiconductor device according to an embodiment.

Referring to FIGS. 1-3, a substrate 110 of a semiconductor device according to an embodiment may include an active area AR and a peripheral area PERI surrounding at least a portion of the active area AR.

The active area AR may be an area in which a semiconductor device according to an embodiment is driven. In the active area AR, a plurality of cells including semiconductor devices such as transistors and diodes may be positioned, and electrodes for supplying signals or power to the cells may also be positioned therein.

In an embodiment, a plurality of cells positioned in the active area AR may include transistor and diode elements. For example, a plurality of cells of a semiconductor device according to an embodiment may include n-type field effect transistor (n-FET) and a diode device. However, example embodiments are not limited thereto, and the plurality of cells may include p-type field effect transistors.

The active area AR of a semiconductor device according to an embodiment may include a transistor area TA in which a transistor is implemented and a diode area DA in which a diode element is implemented. For example, an active area AR may include one or more transistor areas TA and one or more diode areas DA, for example arranged along a particular direction (e.g., the X direction).

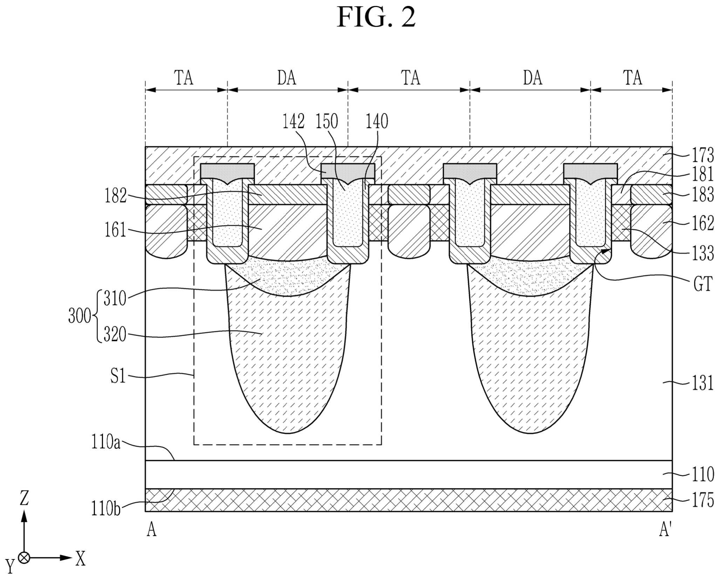

A transistor area TA may be an area where a transistor is located. For example, a source electrode (see 173 in FIG. 2), a gate electrode 150, a well region (see 133 in FIG. 2), and a drain electrode (see 175 in FIG. 2) may be located in the transistor area TA. The well region (see 133 in FIG. 2) may function as a channel that provides an electrical connection path between the source electrode (see 173 in FIG. 2) and the drain electrode (see 175 in FIG. 2) according to the signal of the gate electrode 150. A source electrode (see 173 in FIG. 2), a gate electrode 150, a well region (see 133 in FIG. 2), and a drain electrode (see 175 in FIG. 2) may form a transistor.

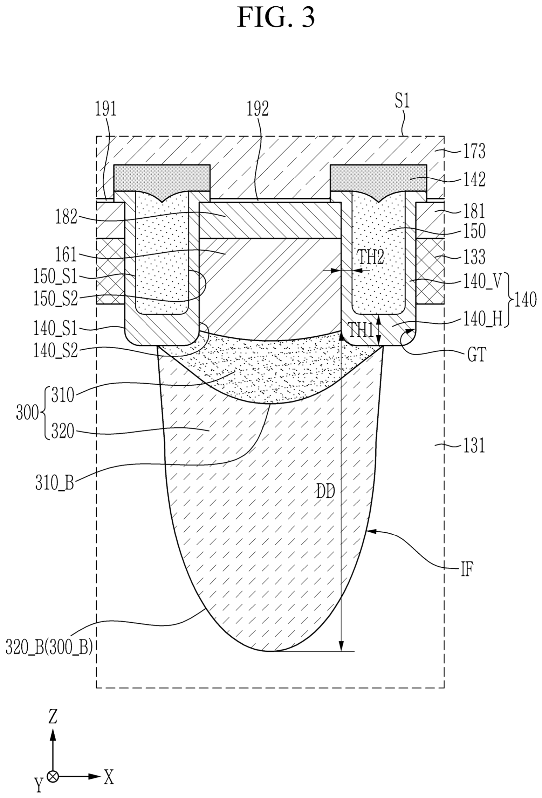

The diode area DA may be the area where the diode element is located. For example, a shield pattern (see 300 in FIG. 2) and an epitaxial layer (see 131 in FIG. 2) may be positioned in the diode area DA, and an interface (see IF in FIG. 3) between the shield pattern (see 300 in FIG. 2) and the epitaxial layer (see 131 in FIG. 2) may form a PN junction, thereby configuring a diode element.

In an embodiment, the transistor area TA and the diode area DA may be defined by a gate trench GT. For example, a semiconductor device according to an embodiment may include a plurality of gate trenches GT extending in a second direction (Y direction) and arranged spaced apart from each other along a first direction (X direction), and a transistor area TA and a diode area DA may be defined by the plurality of gate trenches GT and arranged alternately along the first direction (X direction). Here, the second direction (Y direction) may be a direction intersecting the first direction (X direction). For example, the second direction (Y direction) may be a direction orthogonal to the first direction (X direction). The first direction (X direction) and second direction (Y direction) may be parallel to a first surface (see 110a in FIG. 2) of a substrate (see 110 in FIG. 2).

The transistor area TA and the diode area DA may be positioned between a first portion 211 and a second portion 212 of a gate frame 210, which will be described later. Additionally, the transistor area TA and the diode area DA may be positioned between the second portion 212 and the third portion 213 of the gate frame 210, which will be described later.

The transistor area TA and the diode area DA may extend (e.g., lengthwise) in the second direction (Y direction). Each transistor area TA and diode area DA may extend in the second direction (Y direction) between the first portion 211 and the second portion 212 of the gate frame 210, which will be described later. In this case, the length of the transistor area TA along the second direction (Y direction) may be greater than the length of the transistor area TA along the first direction (X direction), but example embodiments are not limited thereto. Additionally, the length of the diode area DA along the second direction (Y direction) may be greater than the length of the diode area DA along the first direction (X direction), but example embodiments are not limited thereto. The transistor area TA and the diode area DA may be in contact with the gate frame 210, which will be described later.

A peripheral area PERI may surround at least a portion of the active area AR. As illustrated in FIG. 1, when two active areas AR are included on the substrate 110, the peripheral area PERI may surround at least a portion of each of the active areas AR. In an embodiment, the peripheral area PERI is illustrated as having an approximately 'E' shape, surrounding three sides of each of the active areas AR, but example embodiments are not limited thereto. For example, the peripheral area PERI may surround the entire perimeter of the active area AR, or may surround only a portion of the entire perimeter.

The peripheral area PERI may house various configurations for supplying power or electrical signals to the elements in the active area AR. For example, a gate frame 210, which interconnects the elements in the active area AR, may be located in the peripheral area PERI.

A gate frame 210 of a semiconductor device according to an embodiment may surround at least a portion of the active area AR. For example, the gate frame 210 may include a first portion 211, a second portion 212, and a third portion 213 that extend in a first direction (X direction) and are arranged spaced apart from each other along a second direction (Y direction), and may include a fourth portion 214 that extends in the second direction (Y direction) and is electrically connected to the first portion 211 through the third portion 213. In an embodiment, the active area AR may be positioned between the first portion 211 and the second portion 212. The fourth portion 214 may be positioned on one side of the active area AR located between the first portion 211 and the second portion 212. For example, at least a portion of the active area AR may be surrounded by the first portion 211, the second portion 212, and the fourth portion 214. The active area AR may be positioned between the second portion 212 and the third portion 213. The fourth portion 214 may be positioned on one side of the active area AR located between the second portion 212 and the third portion 213. That is, at least a portion of the active area AR may be surrounded by the second portion 212, the third portion 213, and the fourth portion 214. In an embodiment, the gate frame 210 may define the active area AR. For example, the first portion 211 and the second portion 212 of the gate frame 210 may define a transistor area TA and a diode area DA.

In an embodiment, the gate frame 210 may be electrically connected to the active area AR. For example, the gate frame 210 may be electrically connected to the gate electrodes 150 of the active area AR. The gate frame 210 may be positioned on or at the same layer as the gate electrodes 150, but example embodiments are not limited thereto. The gate frame 210 may include the same material as the gate electrodes 150 and the gate frame 210 may be formed integrally with the gate electrodes 150 (e.g., by being formed during the same process of the same material, so that no grain boundaries are formed between the gate electrodes 150 and the gate frame 210), but example embodiments are not limited thereto.

In FIG. 1, three transistor areas TA and two diode areas DA are shown as being arranged alternately along the first direction (X direction) in each active area AR, but the number and positions of transistor areas TA and diode areas DA per active areas AR included on the substrate 110 are not limited thereto. For example, only one or two transistor areas TA and only one diode area DA may be positioned on the substrate 110 in one active area AR, or four or more transistor areas TA and three or more diode areas DA may be arranged in various ways.

In Fig. 1, for convenience of explanation, it is depicted as if there is a boundary between each active area AR and the peripheral area PERI, but there may not be a physical boundary that clearly separates the active area AR and the peripheral area PERI. For example, for each active area AR, the peripheral area PERI and the active area AR may include some overlapping regions near the boundary.

Hereinafter, a plurality of cells of a semiconductor device according to an embodiment will be described with further reference to FIGS. 2 and 3.

FIG.2 is a cross-sectional view taken along line A-A' of FIG.1. FIG.3 is an enlarged cross-sectional view of area S1 of FIG.2.

Referring to FIGS. 2 and 3, a plurality of cells of a semiconductor device according to an embodiment include a substrate 110, an epitaxial layer 131 positioned on a first surface of the substrate 110 and including a gate trench GT, a gate electrode 150 positioned within the gate trench GT, a gate insulating layer 140 positioned between the epitaxial layer 131 and the gate electrode 150, a source electrode 173 positioned on the epitaxial layer 131, a well region 133 positioned between the epitaxial layer 131 and the source electrode 173, a first deep well region 161 positioned between the epitaxial layer 131 and the source electrode 173, a shield pattern 300 positioned between the epitaxial layer 131 and the first deep well region 161 and overlapping the gate electrode 150 (e.g., in a third direction (e.g., a vertical, Z direction)), and a drain electrode 175 positioned on a second surface 110b of the substrate 110.

The substrate 110 may be a semiconductor substrate including SiC. For example, the substrate 110 may be made of a 4H SiC substrate. In some cases, the substrate 110 may be made of a 3C SiC substrate, a 6H SiC substrate, etc. The substrate 110 may have a first conductivity type. The substrate 110 may be heavily doped with the first conductivity type. The first conductivity type may be n-type, but is not limited thereto. The resistivity of the substrate 110 may be about 0.005Ωcm or more and about 0.035Ωcm or less (e.g., within a range from 0.005Ωcm, to 0.035Ωcm). The thickness of the substrate 110 may be about 10 µm or more and about 700 µm or less (e.g., within a range from 10 µm to 700 µm). The material, doping type, doping concentration, resistivity, thickness, etc. of the substrate 110 are not limited thereto and may be changed in various ways.

The substrate 110 may include a first surface 110a and a second surface 110b opposing each other (e.g., opposite to each other, or facing away from each other). The first surface 110a of the substrate 110 may refer to the upper surface of the substrate 110, and the second surface 110b of the substrate 110 may refer to the lower surface of the substrate 110. A third direction (e.g., a vertical direction) may be defined as being perpendicular to one or both of the first surface 110a and the second surface 110b. The epitaxial layer 131 may be positioned on the first surface 110a of the substrate 110. The lower surface of the epitaxial layer 131 may be in contact with (e.g., may be directly connected to) the first surface 110a of the substrate 110. However, example embodiments are not limited thereto, and another layer may be additionally positioned between the substrate 110 and the epitaxial layer 131. The epitaxial layer 131 may be an epitaxial layer formed on the substrate 110 using an epitaxial growth method. The epitaxial layer 131 may include SiC. For example, the epitaxial layer 131 may include 4H SiC. As described herein, certain layers or regions are described as being in contact with each other even though they may, at a microscopic level, have a smooth transition from one layer to the next. This may occur for a second layer formed on a first layer using epitaxial growth, or a second layer different from a first layer due to different amounts of doping within each layer (e.g., where the doping concentration at the interface between the layers is gradual rather than abrupt). It should be understood that such layers described as "in contact" with each other are directly connected to or adjacent to each other with no other layers therebetween at the interface between the two layers. Other uses of "in contact" may refer to different layers formed of different base materials, and which have a grain boundary therebetween.

In an embodiment, the crystal plane of the material comprising the epitaxial layer 131 may be formed at a predetermined angle with respect to the first surface 110a of the substrate 110, e.g., to be nonparallel with the first surface 110a. For example, the crystal plane of the material comprising the epitaxial layer 131 may be tilted by about 4° from the first surface 110a of the substrate 110. For example, when the epitaxial layer 131 includes SiC, the (0001) crystal plane of SiC may be tilted by about 4° from the first surface 110a of the substrate 110. This may be due to the process characteristics for preventing lattice distortion caused by dislocations, etc., within the epitaxial layer 131 during the process of forming the epitaxial layer 131 using the epitaxial growth method.

The epitaxial layer 131 may have a first conductivity type. The epitaxial layer 131 may be lightly doped with a first conductivity type. The first conductivity type may be n-type, but example embodiments are not limited thereto. The doping concentration of the epitaxial layer 131 may be lower than the doping concentration of the substrate 110. The doping concentration of the epitaxial layer 131 (e.g., an average doping concentration) may be about 1*10¹⁵cm⁻³ or more and about 1*10¹⁷cm-³ or less (e.g., within a range from 1*10¹⁵cm⁻³ to 1*10¹⁷cm⁻³). The doping concentration of a layer or region refers to a concentration of dopants within a particular volume of the layer or region, and may refer to an average doping concentration for that volume, for example, where the dopant may have a doping gradient within the volume. A layer, region, or other item describe as "having" a doping concentration (or "has a doping concentration") has that doping concentration with respect to the entire layer, region or item, unless clearly indicated otherwise. A boundary between one region or layer having particular doping and another region or layer that does not have the doping may be a location where doping concentration of the doped region or layer for a small slice of volume drops below a particular value. In addition, in semiconductor technology, if a semiconductor contains both p-type and n-type impurities, the conductivity-type of the semiconductor will be determined by which type of impurity is in greater concentration. Therefore, if a semiconductor has both p-type and n-type impurities, the net conductivity type will be determined by the dominant impurity concentration. As used herein, a semiconductor region of a "first conductivity-type" denotes that the dominant impurities in the semiconductor region is (or are) a first conductivity-type impurity. The thickness of the epitaxial layer 131 (e.g., a maximum thickness in a vertical, Z direction) may be about 1 µm or more and about 13 µm or less (e.g., within a range from 1 µm to 13 µm). The material, doping type, doping concentration, thickness, etc. of the epitaxial layer 131 are not limited thereto and may be changed in various ways.

The epitaxial layer 131 may include a gate trench GT. The gate trench GT may be formed to have a predetermined depth on (e.g., below) the upper surface of the epitaxial layer 131. As illustrated in FIGS. 2 and 3, the gate trench GT may be formed in an approximately U-shape in cross section. The gate trench GT may include a bottom surface and inner side walls extending from the bottom surface. The edge of the gate trench GT where the bottom surface and the inner side wall of the gate trench GT meet may include a curved surface, but is not limited thereto. In FIGS. 2 and 3, the angle of the inner side wall relative to the bottom surface of the gate trench GT is depicted as being vertical (e.g., 90 degrees), but example embodiments are not limited thereto.

The gate trench GT may extend (e.g., lengthwise) in the second direction (Y direction). In an embodiment, a gate trench GT may extend in a second direction (Y direction) between the first portion 211 and the second portion 212 of the gate frame 210, and a gate trench GT may extend (e.g., lengthwise) between the second portion 212 and the third portion 213 of the gate frame 210. The gate trench GT may be in contact with and may extend up to be directly connected to the first portion 211 and the second portion 212 of the gate frame 210. The gate trench GT may be in contact with and may extend up to be directly connected to the second portion 212 and the third portion 213 of the gate frame 210. A semiconductor device according to an embodiment may include a plurality of gate trenches GT extending in a second direction (Y direction) and arranged spaced apart from each other in a first direction (X direction). Each of the plurality of gate trenches GT may extend in a direction parallel to each other. A length of each of the plurality of gate trenches GT along the second direction (Y direction) may be greater than a distance along the first direction (X direction) between the plurality of adjacent gate trenches GT along the first direction (X direction), but example embodiments are not limited thereto.

In an embodiment, each of the plurality of gate trenches GT may include a bottom surface and an inner side wall extending from the bottom surface. The bottom surface of each of the plurality of gate trenches GT may be defined by an epitaxial layer 131 and a shield pattern 300, which will be described later. The inner side wall, or inner side walls, of each of the plurality of gate trenches GT along the first direction (X direction) may be defined by the epitaxial layer 131, a well region 133, which will be described later, a first deep well region 161, a first doped layer 181, a second doped layer 182, and a shield pattern 300. The inner side walls of each of the plurality of gate trenches GT along the second direction (Y direction) may be defined by a gate frame 210. The inner side walls of the plurality of gate trenches GT may extend from the bottom surface of the respective gate trench GT towards the source electrode 173.

The gate electrode 150 may be located within a gate trench GT. The gate electrode 150 may be spaced apart from the epitaxial layer 131. The gate electrode 150 may be spaced apart from the epitaxial layer 131 at a substantially constant interval. However, example embodiments are not limited thereto, and the distance between the gate electrode 150 and the epitaxial layer 131 may vary depending on the position on the gate electrode 150.

The gate electrode 150 may include one side 150_S1 (e.g., a first side) along the first direction (X direction) and another side 150_S2 (e.g., a second side) opposite to the one side 150_S1. The one side 150_S1 of the gate electrode 150 may be a side along the first direction (X direction) of the gate electrode 150 located in the transistor area TA. The one side 150_S1 of the gate electrode 150 may be a side along the first direction (X direction) of the gate electrode 150 facing the well region 133. The other side 150_S2 of the gate electrode 150 may be a side along the first direction (X direction) of the gate electrode 150 located in the diode area DA of the semiconductor device according to an embodiment. For example, the other side 150_S2 of the gate electrode 150 may be a side along the first direction (X direction) of the gate electrode 150 facing the first deep well region 161.

Hereinafter, for convenience of explanation of this embodiment, the side along the first direction (X direction) of the gate electrode 150 located in the transistor area TA is referred to as a transistor-area side 150_S1 of the gate electrode 150, and the side along the first direction (X direction) of the gate electrode 150 located in the diode area DA is referred to as a diode-area side 150_S2 of the gate electrode 150.

The gate electrode 150 may have a cross-sectional shape similar to the gate trench GT. The lower surface and side surfaces 150_S1, 150_S2 of the gate electrode 150 may have an approximately U-shaped cross section along the shape of the gate trench GT. The lower surface of the gate electrode 150 may face the bottom surface of the gate trench GT. The side surfaces 150_S1, 150_S2 of the gate electrode 150 may face the inner side walls of the gate trench GT.

The gate electrode 150 may extend (e.g., lengthwise) in the second direction (Y direction). In an embodiment, the gate electrode 150 extends in the second direction (Y direction) between the first portion 211 and the second portion 212 of the gate frame 210. A length of the gate electrode 150 in the second direction (Y direction) may be substantially equal to a distance between the first portion 211 and the second portion 212. In addition, or alternatively, the gate electrode 150 may extend in the second direction (Y direction) between the second portion 212 and the third portion 213 of the gate frame 210. A length of the gate electrode 150 in the second direction (Y direction) may be substantially equal to a distance between the second portion 212 and the third portion 213. A gate electrode 150 may be in contact with or may be integrally formed with the first portion 211 and the second portion 212 of the gate frame 210, to be directly connected to the first portion 211 and the second portion 212. In addition, or alternatively, a gate electrode 150 may be in contact with or may be integrally formed with the second portion 212 and the third portion 213 of the gate frame 210. In an embodiment, the gate electrode 150 may comprise the same material as the gate frame 210 and may be formed integrally with it, but example embodiments are not limited thereto.

A semiconductor device according to an embodiment may include a plurality of gate electrodes 150 positioned within a plurality of gate trenches GT. Each of the plurality of gate electrodes 150 may extend in a direction parallel to the plurality of gate trenches GT. The plurality of gate electrodes 150 may be arranged spaced apart from each other along the first direction (X direction). A length of each of the plurality of gate electrodes 150 along the second direction (Y direction) may be greater than a distance between the plurality of adjacent gate electrodes 150 along the first direction (X direction), but example embodiments are not limited thereto.

The gate electrode 150 may include a conductive material. For example, the gate electrode 150 may include or be polysilicon doped with impurities. As another example, the gate electrode 150 may include or be a metal, a metal alloy, a conductive metal nitride, a metal silicide, a doped semiconductor material, a conductive metal oxide, a conductive metal nitride, or a combination thereof. The gate electrode 150 may be formed of a single layer or multiple layers.

The gate insulating layer 140 may be positioned between the epitaxial layer 131 and the gate electrode 150. The gate insulating layer 140 may be positioned under the gate electrode 150 and may cover the lower surface of the gate electrode 150. The gate insulating layer 140 may be positioned on the bottom surface and inner side wall of the gate trench GT. The gate insulating layer 140 may surround at least a portion of the gate electrode 150. For example, the gate insulating layer 140 may be positioned on the lower surface, one side 150_S1, and the other side 150_S2 of the gate electrode 150. Accordingly, the gate electrode 150 may be insulated from the epitaxial layer 131 by the gate insulating layer 140.

In an embodiment, the gate insulating layer 140 may be positioned between the shield pattern 300 and the gate electrode 150, further details of which will be described later. In addition, the gate insulating layer 140 may be positioned between the well region 133, which will be described later, and the gate electrode 150, between the first deep well region 161, which will be described later, and the gate electrode 150, between the first doped layer 181, which will be described later, and the gate electrode 150, and between the second doped layer 182, which will be described later, and the gate electrode 150.

In an embodiment, the gate insulating layer 140 may include one side 140_S1 along the first direction (X direction) and the other side 140_S2 opposite to the one side 140_S1. One side 140_S1 of the gate insulating layer 140 may mean a side along the first direction (X direction) of the gate insulating layer 140 located in the transistor area TA of the semiconductor device according to an embodiment. The one side 140_S1 of the gate insulating layer 140 may be a side along the first direction (X direction) of the gate insulating layer 140 facing the well region 133, which will be described later. The other side 140_S2 of the gate insulating layer 140 may refer to a side along the first direction (X direction) of the gate insulating layer 140 located in the diode area DA of the semiconductor device according to an embodiment. The other side 140_S2 of the gate insulating layer 140 may be a side along the first direction (X direction) of the gate insulating layer 140 facing the first deep well region 161.

The gate insulating layer 140 of a semiconductor device according to an embodiment may include a horizontal portion 140_H positioned between the epitaxial layer 131 and a gate electrode 150 and a vertical portion 140_V positioned on one side 150_S1 of the gate electrode 150 and the other side 150_S2 of the gate electrode 150.

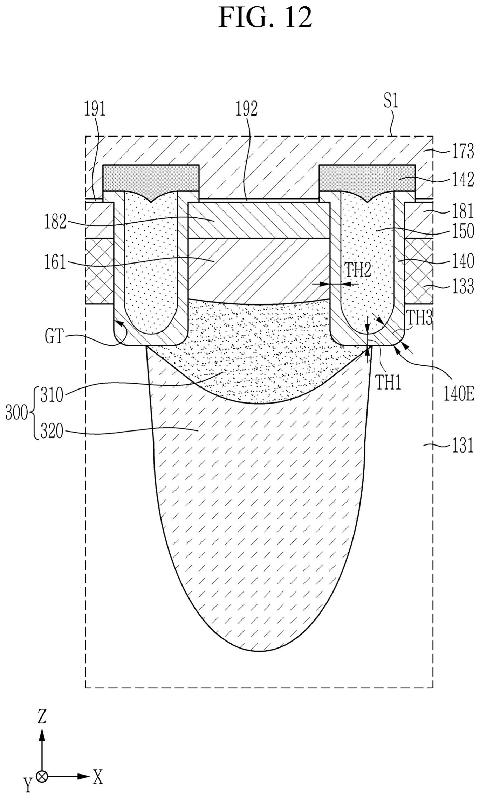

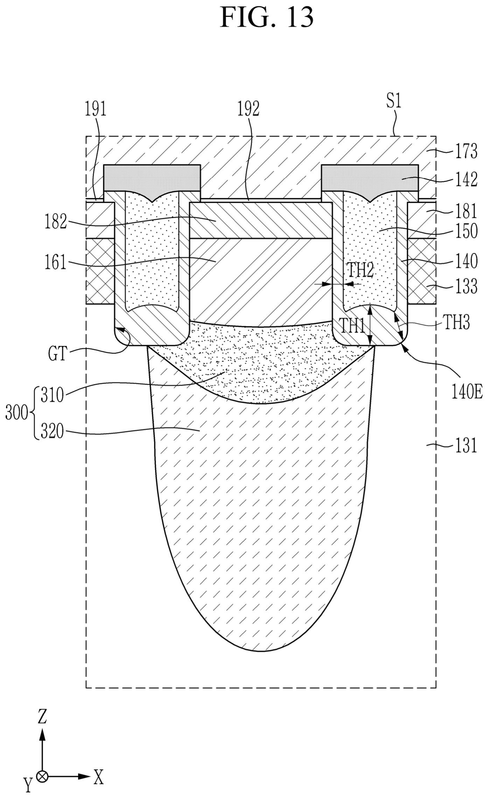

The horizontal portion 140_H may be positioned between the epitaxial layer 131 and the gate electrode 150. Additionally, the horizontal portion 140_H may be positioned between the shield pattern 300 and the gate electrode 150, which will be described later. In an embodiment, when viewed from a direction parallel to a lengthwise extension direction of the gate electrode 150 (e.g., the Y direction), the horizontal portion 140_H may extend a greater amount in the horizontal direction (e.g., X direction) than in the vertical direction (e.g., Z direction). In an embodiment, the horizontal portion 140_H may have a first thickness TH1 along the third direction (Z direction), wherein the first thickness TH1 corresponds to a thickness from a bottom surface that contacts the epitaxial layer 131 and shield pattern 300 to a top surface that contacts a bottom surface of the gate electrode 150. The first thickness TH1 along the third direction (Z direction) of the horizontal portion 140_H may be constant, but example embodiments are not limited thereto. For example, the first thickness TH1 along the third direction (Z direction) of the horizontal portion 140_H may gradually decrease or increase from the center of the horizontal portion 140_H (e.g., center along the X direction) to the opposite edges. An explanation of this will be given later with reference to FIGS. 12 and 13.

The vertical portion 140_V may be positioned on one side 150_S1 and the other side 150_S2 of the gate electrode 150. The vertical portion 140_V may comprise two vertical portions 140_V, one positioned on one side 150_S1 and another positioned on the other side 150_S2 of the gate electrode 150. Nevertheless, for simplicity, the vertical portion(s) shall be referred to herein as the vertical portion 140_V. The vertical portion 140_V may be positioned between the well region 133, which will be described later and the gate electrode 150 and between the first deep well region 161, which will be described later and the gate electrode 150. The gate electrode 150 may be electrically insulated from the well region 133 and the first deep well region 161 by the vertical portion 140_V. When viewed from a direction parallel to a lengthwise extension direction of the gate electrode 150 (e.g., the Y direction), the vertical portion 140_V may extend a greater amount in the vertical direction (e.g., Y direction) than in the horizontal direction (e.g., X direction)

The vertical portion 140_V may have a second thickness TH2 along the first direction (X direction). The second thickness TH2 along the first direction (X direction) of the vertical portion 140_V may be smaller than the first thickness TH1 along the third direction (Z direction) of the horizontal portion 140_H. Accordingly, the distance along the third direction (Z direction) between the gate electrode 150 and the epitaxial layer 131 may be greater than the distance along the first direction (X direction) between the gate electrode 150 and the well region 133, which will be described later. Accordingly, due at least in part to having a thicker bottom portion compared to side wall portions, it is possible to prevent the electric field formed from the drain electrode 175 and/or the epitaxial layer 131 from being concentrated on the gate electrode 150, and improve the breakdown voltage of the semiconductor device according to an embodiment.

In an embodiment, the second thickness TH2 along the first direction (X direction) of the vertical portion 140_V may be constant, but example embodiments are not limited thereto. For example, the second thickness TH2 along the first direction (X direction) of the vertical portion 140_V may gradually decrease or increase from the center of the vertical portion 140_V to opposite edges.

The gate insulating layer 140 may include or be an insulating material. For example, the gate insulating layer 140 may include or be SiO₂. However, example embodiments are not limited thereto, and the material of the gate insulating layer 140 may be changed in various ways. As another example, the gate insulating layer 140 may include or be one or more of SiN, SiON, SiC, and SiCN. The gate insulating layer 140 may be formed of a single layer or multiple layers.

A semiconductor device according to an embodiment may further include a capping layer 142 positioned on a gate electrode 150. The capping layer 142 may cover the upper surface of the gate electrode 150. Additionally, the capping layer 142 may cover the gate insulating layer 140 adjacent to the gate electrode 150, at least a portion of the first doped layer 181, which will be described later, and at least a portion of the second doped layer 182, which will be described later. The capping layer 142 may be positioned between the gate electrode 150 and the source electrode 173, which will be described later. The gate electrode 150 may be insulated from the source electrode 173 by the capping layer 142.

The thickness of the capping layer 142 in the third direction (Z direction) may gradually decrease from the center of the capping layer 142 to opposite edges. However, example embodiments are not limited thereto, and the thickness of the capping layer 142 along the third direction (Z direction) may be constant or almost constant. The thickness of the capping layer 142 (e.g., along the Z direction) may be different from the thickness of the gate insulating layer 140 (e.g., along the Z direction). For example, the thickness of the capping layer 142 may be thicker than the thickness of the gate insulating layer 140. In some cases, the thickness of the capping layer 142 may be similar to the thickness of the gate insulating layer 140.

The capping layer 142 may include or be formed of an insulating material. For example, the capping layer 142 may include or be formed of one or more of SiO₂, SiOP, SiN, and SiON. However, example embodiments are not limited thereto, and the material of the capping layer 142 may be changed in various ways. The capping layer 142 may be formed of a single layer or multiple layers. The capping layer 142 may include the same material as the gate insulating layer 140 or may include a different material. When the capping layer 142 is made of the same material as the gate insulating layer 140, the boundary between the capping layer 142 and the gate insulating layer 140 may not be clearly distinguished at the portion where the capping layer 142 and the gate insulating layer 140 come into contact.

The source electrode 173 may be positioned on the epitaxial layer 131. The source electrode 173 may be positioned on the first doped layer 181, the second doped layer 182, and the third doped layer 183, which will be described later.

The source electrode 173 may be positioned apart from the gate trench GT. The source electrode 173 may be positioned spaced apart from the gate trench GT along the third direction (Z direction).

The source electrode 173 may include a conductive material. For example, the source electrode 173 may include a metal, a metal alloy, a conductive metal nitride, a metal silicide, a doped semiconductor material, a conductive metal oxide, or a conductive metal nitride. For example, the source electrode 173 may be formed of or include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbide nitride (TiAIC-N), titanium aluminum carbide (TiAIC), titanium carbide (TiC), tantalum carbide nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combinations thereof. The source electrode 173 may be formed of a single layer or multiple layers.

The well region 133 may be positioned on the epitaxial layer 131. The well region 133 may be positioned on the epitaxial layer 131 located in the transistor area TA. The well region 133 may be positioned between the epitaxial layer 131 and the source electrode 173. The well region 133 may be positioned on one side 150_S1 of the gate electrode 150. The well region 133 may face the gate electrode 150 with the gate insulating layer 140 interposed therebetween. The well region 133 may be in contact with one side 140_S1 of the gate insulating layer 140. The lower surface of the well region 133 may be in contact with the epitaxial layer 131. The well region 133 may not be located on the other side 150_S2 of the gate electrode 150. The well region 133 may not overlap with the first deep well region 161 or the shield pattern 300 in the third direction (Z direction), which will be described later. For instance, the well region 133 may be offset from the first deep well region 161 or the shield pattern 300 in the first direction (X direction).

The well region 133 may include SiC. For example, the well region 133 may include 4H SiC. The well region 133 may have a second conductivity type that is different from the first conductivity type. The well region 133 may be lightly doped with a second conductivity type. The second conductivity type may be p-type, but is not limited thereto. The doping concentration of the well region 133 may be about 1*10¹⁷cm⁻³ or more and about 1*10¹⁹cm⁻³ or less (e.g., within a range from 1*10¹⁷cm⁻³ to1*10¹⁹cm⁻³). The thickness of the well region 133 may be about 0.3 µm or more and about 1.1 µm or less (e.g., within a range from 0.3 µm to 1.1 µm), but example embodiments are not limited thereto. The material, doping type, doping concentration, thickness, etc. of the well region 133 are not limited thereto and may be changed in various ways.

The well region 133 may be a doped region formed using an ion implantation process within the epitaxial layer 131. For example, the well region 133 may be formed using a random ion implantation process. Alternatively, the well region 133 may be an epitaxial layer formed using an epitaxial growth method from the epitaxial layer 131.

The first deep well region 161 may be positioned on the epitaxial layer 131. The first deep well region 161 may be positioned on the epitaxial layer 131 located in the diode area DA. The first deep well region 161 may be positioned between the epitaxial layer 131 and the source electrode 173. The first deep well region 161 may be positioned on the other side 150_S2 of the gate electrode 150. The first deep well region 161 may face the gate electrode 150 with the gate insulating layer 140 interposed therebetween. A lower surface of the first deep well region 161 may be in contact with the shield pattern 300, which will be described later. The lower surface of the first deep well region 161 may not be in contact with the epitaxial layer 131, but example embodiments are not limited thereto. The first deep well region 161 may not be positioned on one side 150_S1 of the gate electrode 150. The first deep well region 161 may not overlap with the well region 133 in the third direction (Z direction).

The first deep well region 161 may have a predetermined depth. For example, the lower surface of the first deep well region 161 may be located at a lower level than the lower surface of the well region 133. The lower surface of the first deep well region 161 may be located closer to the first surface 110a of the substrate 110 than the lower surface of the well region 133 is to the first surface 110a of the substrate 110. The distance (e.g., minimum distance) between the lower surface of the first deep well region 161 and the first surface 110a of the substrate 110 may be smaller than the distance (e.g., minimum distance) between the lower surface of the well region 133 and the first surface 110a of the substrate 110. The upper surface of the first deep well region 161 may be located at substantially the same level as the upper surface of the well region 133, but example embodiments are not limited thereto. The thickness (e.g. a maximum thickness) of the first deep well region 161 along the third direction (Z direction) may be greater than the thickness of the well region 133 along the third direction (Z direction). Accordingly, the breakdown voltage of the transistor may be prevented from decreasing due to an electric field generated by a voltage applied to the gate electrode 150. The first deep well region 161 may overlap with the well region 133 in the first direction (X direction).

The first deep well region 161 may include SiC. For example, the first deep well region 161 may include 4H SiC. The first deep well region 161 may have a second conductivity type. The first deep well region 161 may be doped with a second conductivity type. The second conductivity type may be p-type, but is not limited thereto. The doping concentration of the first deep well region 161 may be greater than the doping concentration of the well region 133. Accordingly, the breakdown voltage of the transistor may be prevented from decreasing due to an electric field generated by a voltage applied to the gate electrode 150. The material, doping type, doping concentration, thickness, etc. of the first deep well region 161 are not limited thereto and may be changed in various ways.

The first deep well region 161 may be a doped region formed using an ion implantation process within the epitaxial layer 131. For example, the first deep well region 161 may be formed using a random ion implantation process. Alternatively, the first deep well region 161 may be an epitaxial layer formed using an epitaxial growth method from the epitaxial layer 131.

A semiconductor device according to an embodiment may further include a second deep well region 162 positioned between the epitaxial layer 131 and the source electrode 173.

The second deep well region 162 may be positioned on the epitaxial layer 131. The second deep well region 162 may be positioned on the epitaxial layer 131 located in the transistor area TA. The second deep well region 162 may be positioned between the epitaxial layer 131 and the source electrode 173. The second deep well region 162 may be positioned on one side of the well region 133. The second deep well region 162 may be positioned on one side 150_S1 of the gate electrode 150. The second deep well region 162 may face the gate insulating layer 140 with the well region 133 interposed therebetween. The well region 133 may be positioned between the second deep well region 162 and the gate insulating layer 140. A lower surface of the second deep well region 162 may be in contact with the epitaxial layer 131. The lower surface of the second deep well region 162 may not be in contact with the shield pattern 300, which will be described later, but example embodiments are not limited thereto. The second deep well region 162 may not be located on the other side 150_S2 of the gate electrode 150.

The second deep well region 162 may have a predetermined depth. For example, the lower surface (e.g., lowermost surface) of the second deep well region 162 may be located at a lower level than the lower surface (e.g., lowermost surface) of the well region 133. The lower surface of the second deep well region 162 may be located closer to the first surface 110a of the substrate 110 than the lower surface of the well region 133 is to the first surface 110a of the substrate 110. The upper surface of the second deep well region 162 may be located at substantially the same level as the upper surface of the well region 133, but example embodiments are not limited thereto. In an embodiment, the thickness (e.g., maximum thickness) of the second deep well region 162 along the third direction (Z direction) may be greater than the thickness (e.g., maximum thickness) of the well region 133 along the third direction (Z direction). Accordingly, the breakdown voltage of the transistor may be prevented from decreasing due to an electric field generated by a voltage applied to the gate electrode 150.

In an embodiment, the thickness (e.g., maximum thickness) of the second deep well region 162 along the third direction (Z direction) may be substantially the same as the thickness (e.g., maximum thickness) of the first deep well region 161 along the third direction (Z direction). The lower surface of the second deep well region 162 may be positioned at substantially the same distance from the first surface 110a of the substrate 110 as the lower surface of the first deep well region 161 is from the first surface 110a of the substrate, but example embodiments are not limited thereto.

The second deep well region 162 may include the same material as the first deep well region 161. The second deep well region 162 may be formed simultaneously with the first deep well region 161 in the same process. For example, the second deep well region 162 may include SiC. As another example, the second deep well region 162 may include 4H SiC. The second deep well region 162 may have a second conductivity type. The second deep well region 162 may be doped with a second conductivity type. The second conductivity type may be p-type, but not limited thereto.

The doping concentration of the second deep well region 162 may be greater than the doping concentration of the well region 133. Accordingly, the second deep well region 162 may prevent the breakdown voltage of the transistor from decreasing due to an electric field generated by a voltage applied to the gate electrode 150. The doping concentration of the second deep well region 162 may be substantially the same as the doping concentration of the first deep well region 161. However, example embodiments are not limited thereto, and for example, the doping concentration of the second deep well region 162 may be greater than the doping concentration of the first deep well region 161. As another example, the doping concentration of the second deep well region 162 may be less than the doping concentration of the first deep well region 161. The material, doping type, doping concentration, thickness, etc. of the second deep well region 162 are not limited thereto and may be changed in various ways.

The second deep well region 162 may be a doped region formed using an ion implantation process within the epitaxial layer 131. For example, the second deep well region 162 may be formed using a random ion implantation process. Alternatively, the second deep well region 162 may be an epitaxial layer formed using an epitaxial growth method from the epitaxial layer 131.

A semiconductor device according to an embodiment may further include a first doped layer 181 positioned on a well region 133, a second doped layer 182 positioned on a first deep well region 161, and a third doped layer 183 positioned on the second deep well region 162.

The first doped layer 181 may be positioned on the epitaxial layer 131. The first doped layer 181 may be positioned on the epitaxial layer 131 located in the transistor area TA. The first doped layer 181 may be positioned on the well region 133. For example, the first doped layer 181 may be positioned directly on the upper surface of the well region 133. The first doped layer 181 may be positioned between the well region 133 and the source electrode 173. One surface of the first doped layer 181 may be in contact with the well region 133, and the other surface of the first doped layer 181 may be in contact with a first silicide layer 191 or the source electrode 173.

The first doped layer 181 may be positioned on one side 150_S1 of the gate electrode 150. The first doped layer 181 may face the gate electrode 150 with the gate insulating layer 140 interposed therebetween. The surface of the first doped layer 181 facing the gate electrode 150 may be positioned on the same boundary as the side wall of the gate trench GT. The upper surface of the first doped layer 181 may be in contact with the first silicide layer 191, which will be described later, and the lower surface of the first doped layer 181 may be in contact with the well region 133. However, example embodiments are not limited thereto, and another layer of a predetermined type may be positioned between the first doped layer 181 and the source electrode 173. At least a portion of the upper surface of the first doped layer 181 may be covered by a capping layer 142, but example embodiments are not limited thereto. The source electrode 173 and the first silicide layer 191 may be in ohmic contact with the first doped layer 181.

The first doped layer 181 may be formed using an ion implantation process within the well region 133. The first doped layer 181 may include SiC. For example, the first doped layer 181 may include 4H SiC. The first doped layer 181 may have a first conductivity type. The first doped layer 181 may be doped with the first conductivity type. The first conductivity type may be n-type, but is not limited thereto. The region in contact with the first silicide layer 191 within the first doped layer 181 may be doped at a relatively high concentration compared to other regions. The doping concentration of the first doped layer 181 may be greater than the doping concentration of the epitaxial layer 131. The doping concentration of the first doped layer 181 may be about 1*10¹⁸cm⁻³ or more and about 5*10²⁰cm⁻³ or less (e.g., within a range from 1*10¹⁸cm⁻³ to 5*10²⁰cm⁻³). The thickness of the first doped layer 181 may be about 0.1 µm or more and about 0.5 µm or less (e.g., within a range from 0.1 µm or more and 0.5 µm). The material, doping type, doping concentration, etc. of the first doped layer 181 are not limited thereto and may be changed in various ways.

The second doped layer 182 may be positioned on the first deep well region 161. The first doped layer 181 may be positioned on the first deep well region 161 located in the diode area DA. The second doped layer 182 may be positioned between the first deep well region 161 and the source electrode 173. One surface of the second doped layer 182 may be in contact with the first deep well region 161, and the other surface of the second doped layer 182 may be in contact with a second silicide layer 192 or the source electrode 173.

The second doped layer 182 may be positioned on the other side 150_S2 of the gate electrode 150. The second doped layer 182 may face the gate electrode 150 with the gate insulating layer 140 interposed therebetween. The surface of the second doped layer 182 facing the gate electrode 150 may be positioned on the same boundary line as the side wall of the gate trench GT. The upper surface of the second doped layer 182 may be in contact with the second silicide layer 192, which will be described later, and the lower surface of the second doped layer 182 may be in contact with the second deep well region 162. However, example embodiments are not limited thereto, and another layer of a predetermined type may be positioned between the second doped layer 182 and the source electrode 173. At least a portion of the upper surface of the second doped layer 182 may be covered by a capping layer 142, but example embodiments are not limited thereto. The source electrode 173 and the second silicide layer 192 may be in ohmic contact with the second doped layer 182.

The second doped layer 182 may be formed using an ion implantation process within the epitaxial layer 131. The second doped layer 182 may include SiC. For example, the second doped layer 182 may include 4H SiC. The second doped layer 182 may have a second conductivity type. The second doped layer 182 may be heavily doped with the second conductivity type. The second conductivity type may be p-type, but not limited thereto. The doping concentration of the second doped layer 182 may be greater than the doping concentration of the first deep well region 161 and the doping concentration of the second deep well region 162. The doping concentration of the second doped layer 182 may be about 1*10¹⁸cm⁻³ or more and about 5*10²⁰cm⁻³ or less (e.g., within a range from 1*10¹⁸cm⁻³ or more and about 5*10²⁰cm⁻³). The material, doping type, doping concentration, etc. of the second doped layer 182 are not limited thereto and may be changed in various ways.

The third doped layer 183 may be positioned on the second deep well region 162. The first doped layer 181 may be positioned on the second deep well region 162 located in the transistor area TA. The third doped layer 183 may be positioned between the second deep well region 162 and the source electrode 173.

In an embodiment, the third doped layer 183 may be positioned on one side of the first doped layer 181. For example, the third doped layer 183 may be positioned on one side of the first doped layer 181 along the first direction (X direction). For example, the first doped layer 181 may be positioned between the third doped layer 183 and the gate electrode 150. The third doped layer 183 may be positioned spaced apart from the gate trench GT in the first direction (X direction). The third doped layer 183 may be positioned spaced apart from the gate insulating layer 140 in the first direction (X direction).

The third doped layer 183 may be located in the same layer as the first doped layer 181. The upper surface of the third doped layer 183 may be positioned at substantially the same level as the upper surface of the first doped layer 181. For example, the upper surface of the third doped layer 183 may be positioned at substantially the same distance from the first surface 110a of the substrate 110 as the upper surface of the first doped layer 181 is from the first surface 110a of the substrate 110. The lower surface of the third doped layer 183 may be located at the same level as the lower surface of the first doped layer 181, but example embodiments are not limited thereto. For example, in some embodiments the lower surface of the third doped layer 183 may be located at a lower level than the lower surface of the first doped layer 181, such that the lower surface of the third doped layer 183 is located closer to the first surface 110a of the substrate 110 than the lower surface of the first doped layer 181 is to the first surface 110a of the substrate, but example embodiments are not limited thereto.

The third doped layer 183 may be formed using an ion implantation process within the epitaxial layer 131. The third doped layer 183 may include SiC. For example, the third doped layer 183 may include 4H SiC. The third doped layer 183 may have a second conductivity type. The third doped layer 183 may be heavily doped with the second conductivity type. The second conductivity type may be p-type, but not limited thereto. The doping concentration of the third doped layer 183 may be greater than the doping concentration of the first deep well region 161 and the doping concentration of the second deep well region 162. The doping concentration of the third doped layer 183 may be substantially the same as the doping concentration of the second doped layer 182, but example embodiments are not limited thereto. The doping concentration of the third doped layer 183 may be about 1*10¹⁸cm⁻³ or more and about 5*10²⁰cm⁻³ or less (e.g., within a range from 1*10¹⁸cm⁻³ to 5*10²⁰cm⁻³). The material, doping type, doping concentration, etc. of the third doped layer 183 are not limited thereto and may be changed in various ways.

A semiconductor device according to an embodiment may further include silicide layers 191, 192 positioned between the source electrode 173 and the well region 133. The silicide layers 191, 192 may include a first silicide layer 191 positioned between the first doped layer 181 and the source electrode 173 and between the third doped layer 183 and the source electrode 173, and a second silicide layer 192 positioned between the second doped layer 182 and the source electrode 173.

The first doped layer 181 and the source electrode 173 and the third doped layer 183 and the source electrode 173 may be electrically connected (e.g., smoothly connected) by the first silicide layer 191. Additionally, the second doped layer 182 and the source electrode 173 may be electrically connected (e.g., smoothly connected) by the second silicide layer 192. For instance, the first silicide layer 191 may reduce the resistance between the first doped layer 181 and the source electrode 173 and between the third doped layer 183 and the source electrode 173. Similarly, the second silicide layer 192 may reduce the resistance between the second doped layer 182 and the source electrode 173.

The shield pattern 300 may be positioned on the epitaxial layer 131. The shield pattern 300 may be positioned on an epitaxial layer 131 (e.g., a region of the epitaxial layer 131) located in the diode area DA. The shield pattern 300 may be positioned between the epitaxial layer 131 and the first deep well region 161. The shield pattern 300 may not be located in the transistor area TA. The shield pattern 300 may overlap the first deep well region 161 in the third direction (Z direction). The shield pattern 300 may be electrically connected to the source electrode 173 through the second doped layer 182 and the first deep well region 161.

In an embodiment, the shield pattern 300 may overlap the gate trench GT in a third direction (Z direction). The shield pattern 300 may overlap the gate electrode 150 in the third direction (Z direction). The shield pattern 300 may overlap the gate insulating layer 140 in the third direction (Z direction). The shield pattern 300 does not overlap with the well region 133 in the third direction (Z direction). The upper surface of the shield pattern 300 may be in contact with the lower surface of the first deep well region 161 and the lower surface of the gate insulating layer 140. The lower surface 300_B of the shield pattern 300 may come into contact with the epitaxial layer 131.

The shield pattern 300 may extend in the second direction (Y direction). In an embodiment, the shield pattern 300 may extend in a second direction (Y direction) between the first portion 211 and the second portion 212 of the gate frame 210 and between the second portion 212 and the third portion 213. The length of each shield pattern 300 in the second direction (Y direction) may be substantially equal to the distance between the first portion 211 and the second portion 212.

The shield pattern 300 may be formed to have a predetermined depth from the lower surface of the first deep well region 161. The thickness DD of the shield pattern 300 along the third direction (Z direction) (e.g., a distance in the Z direction between an uppermost surface of the shield pattern 300 and a lowermost surface of the shield pattern 300) may be greater than the depth of the gate trench GT along the third direction (Z direction). For example, the thickness DD of the shield pattern 300 in the third direction (Z direction) may be about two to three times the depth of the gate trench GT in the third direction (Z direction), but example embodiments are not limited thereto. The depth of the gate trench GT in the third direction (Z direction) may be measured between a level of an upper surface of the first doped layer 181 (or the second doped layer 182) and the bottom surface of the gate trench GT. The thickness DD of the shield pattern 300 along the third direction (Z direction) may be greater than the thickness of the well region 133 along the third direction (Z direction). The thickness DD of the shield pattern 300 along the third direction (Z direction) may be greater than the thickness of the first deep well region 161 along the third direction (Z direction). Accordingly, the shield pattern 300 may prevent the breakdown voltage of the transistor from being reduced due to an electric field generated by a voltage applied to the gate electrode 150. Here, the thickness DD of the shield pattern 300 along the third direction (Z direction) may be the maximum length along the third direction (Z direction) between the upper surface (e.g., a highest portion of the upper surface in the Z direction) of the shield pattern 300 in contact with the first deep well region 161 and the lower surface (e.g., a lowest portion of the lower surface in the Z direction) of the shield pattern 300. The third direction (Z direction) may be a direction intersecting the first direction (X direction) and the second direction (Y direction), and the third direction (Z direction) may be a vertical direction perpendicular to the first surface 110a of the substrate 110.

Additionally, in an embodiment, the thickness DD of the shield pattern 300 along the third direction (Z direction) may be smaller than the distance along the third direction (Z direction) between the first deep well region 161 and the drain electrode 175. Accordingly, the shield pattern 300 and the drain electrode 175 may be spaced apart in the third direction (Z direction), and the interface IF between the shield pattern 300 and the epitaxial layer 131 located between the shield pattern 300 and the drain electrode 175 may form a PN junction interface. In one embodiment, the thickness DD of the shield pattern 300 along the third direction (Z direction) may be smaller than the distance along the third direction (Z direction) between the first deep well region 161 and the substrate 101 (e.g., the first surface 101a of the substrate 101). Accordingly, the shield pattern 300 and the substrate 110 may be spaced apart in the third direction (Z direction), and the interface IF between the shield pattern 300 and the epitaxial layer 131 located between the shield pattern 300 and the substrate 110 may form a PN junction interface.

The lower surface 300_B of the shield pattern 300 may include a convex curved surface toward the drain electrode 175. For example, the lower surface 300_B of the shield pattern 300 may have a convex shape toward the first surface 110a of the substrate 110. This may be due to the process characteristics of forming a shield pattern 300 using a channeling ion implantation process and/or a high energy implant process within the epitaxial layer 131. The term "convex shape toward" a particular element, may refer to a surface facing towards the particular element that is convex. For instance, the lower surface 300_B of the shield pattern 300 may include a convex curved surface toward the drain electrode 175 such that the lower surface 300_B of the shield pattern 300 protrudes towards the drain electrode 175.

The width of the shield pattern 300 along the first direction (X direction) may be greater than or equal to the width of the first deep well region 161 along the first direction (X direction). For example, the width (e.g., the maximum width) of the shield pattern 300 in the first direction (X direction) may be greater than or equal to the distance between adjacent gate trenches GT in the first direction (X direction). Accordingly, at least a portion of the shield pattern 300 may overlap the gate insulating layer 140 located within the gate trench GT in the third direction (Z direction). The width of the shield layer 300 in the first direction (X direction) may be less than or equal to the distance in the first direction (X direction) between adjacent well regions 133 in the first direction (X direction).

The shield pattern 300 may be a doped region formed using an ion implantation process within the epitaxial layer 131. For example, at least a portion of the shield pattern 300 may be a doped region formed using a channeling ion implantation process and/or a high energy implant process, and the remaining portion may be a doped region formed using a random ion implantation process. The shield pattern 300 may include SiC. For example, the shield pattern 300 may include 4H SiC. The shield pattern 300 may have the same conductivity type as the well region 133 and the third doped layer 183. The shield pattern 300 may have a second conductivity type. The shield pattern 300 may be doped with a second conductivity type. The second conductivity type may be p-type, but is not limited thereto. In this case, the doping concentration of the shield pattern 300 may be greater than the doping concentration of the well region 133. The doping concentration of the shield pattern 300 may be greater than or equal to the doping concentrations of the first deep well region 161 and the second deep well region 162. The doping concentration of the shield pattern 300 may be smaller than the doping concentration of the second doped layer 182. Accordingly, the shield pattern 300 may effectively alleviate the electric field generated around the gate electrode 150. In some embodiments, the shield pattern 300 may be composed of a single layer or multiple layers.

A shield pattern 300 of a semiconductor device according to an embodiment may include a first shield layer 310 positioned on a lower surface of a first deep well region 161 and a lower surface of a gate insulating layer 140, and a second shield layer 320 positioned between the first shield layer 310 and an epitaxial layer 131.

The first shield layer 310 may be located below the first deep well region 161 and the gate insulating layer 140. The first shield layer 310 may be located under the gate trench GT. The first shield layer 310 may be positioned on the lower surface of the gate trench GT.

The upper surface of the first shield layer 310 may be in contact with the gate insulating layer 140 and the first deep well region 161. The first shield layer 310 may overlap the gate trench GT in the third direction (Z direction). The first shield layer 310 may overlap the gate electrode 150 in the third direction (Z direction). The first shield layer 310 does not overlap with the well region 133 in the third direction (Z direction). Additionally, the first shield layer 310 does not overlap with the first doped layer 181 or the third doped layer 183 in the third direction (Z direction).

The width (e.g., the maximum width) of the first shield layer 310 along the first direction (X direction) may be greater than or equal to the width (e.g., the maximum width) of the first deep well region 161 along the first direction (X direction). For example, the width of the first shield layer 310 in the first direction (X direction) may be greater than or equal to the distance in the first direction (X direction) between adjacent gate trenches GT in the first direction (X direction). The width of the first shield layer 310 in the first direction (X direction) may be less than or equal to the distance in the first direction (X direction) between adjacent well regions 133 in the first direction (X direction). Here, the width of the first shield layer 310 along the first direction (X direction) may be the maximum width of the first shield layer 310 along the first direction (X direction). Accordingly, at least a portion of the first shield layer 310 may overlap the gate insulating layer 140 located within the gate trench GT in the third direction (Z direction). Accordingly, the first shield layer 310 may effectively alleviate the electric field generated around the gate electrode 150.

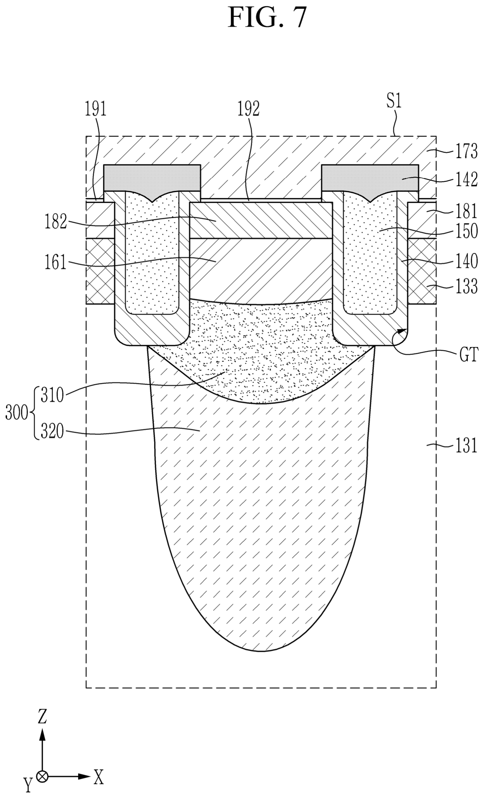

The upper surface of the first shield layer 310 may be located at a higher level than the lower surface of the gate insulating layer 140. The upper surface of the first shield layer 310 may be located further from the first surface 110a of the substrate 110 than the lower surface of the gate insulating layer 140. The distance between the upper surface of the first shield layer 310 and the first surface 110a of the substrate 110 may be greater than the distance between the lower surface of the gate insulating layer 140 and the first surface 110a of the substrate 110. Accordingly, the first shield layer 310 may overlap at least a portion of the gate insulating layer 140 in a horizontal direction (the first direction (X direction) and/or the second direction (Y direction)). The first shield layer 310 may be in contact with at least a portion of the other side 140_S2 of the gate insulating layer 140. In an embodiment, the upper surface of the first shield layer 310 may be located at a lower level than the lower surface of the gate electrode 150, though the embodiments are not limited thereto. The upper surface of the first shield layer 310 may be located closer to the first surface 110a of the substrate 110 than the lower surface of the gate electrode 150 is to the first surface 110a of the substrate 110. In one embodiment, the first shield layer 310 does not overlap with the gate electrode 150 in the horizontal direction (first direction (X direction) and/or second direction (Y direction)). However, example embodiments are not limited thereto, and for example, the first shield layer 310 may overlap the gate electrode 150 in the horizontal direction (first direction (X direction) and/or second direction (Y direction)). Further explanation of this example is illustrated in Fig. 7.

The lower surface 310_B of the first shield layer 310 may include a convex curved surface toward the drain electrode 175. For example, the lower surface 310_B of the first shield layer 310 may have a convex shape toward the first surface 110a of the substrate 110. Accordingly, the lower surface 310_B of the first shield layer 310 may protrude towards the first surface 110a of the substrate 110. This may be due to the process characteristics of forming the first shield layer 310 using an ion implantation process within the epitaxial layer 131. The ion implantation process may be, for example, a random ion implantation process.

The first shield layer 310 may have a second conductivity type. The first shield layer 310 may be doped with a second conductivity type. Here, the second conductivity type may be p-type, but example embodiments are not limited thereto.

The second shield layer 320 may be positioned between the epitaxial layer 131 and the first shield layer 310. The second shield layer 320 may protrude from the lower surface 310_B of the first shield layer 310 toward the first surface 110a of the substrate 110. The upper surface of the second shield layer 320 may be in contact with the first shield layer 310, and the lower surface 320_B of the second shield layer 320 may be in contact with the epitaxial layer 131. The second shield layer 320 may overlap the gate trench GT in the third direction (Z direction). The second shield layer 320 may overlap the gate electrode 150 in the third direction (Z direction). The second shield layer 320 does not overlap with the well region 133 in the third direction (Z direction). Additionally, the second shield layer 320 does not overlap with the first doped layer 181 or the third doped layer 183 in the third direction (Z direction). The second shield layer 320 may be electrically connected to the drain electrode 175 through the epitaxial layer 131.

The width (e.g., the maximum width) of the second shield layer 320 along the first direction (X direction) may be greater than or equal to the width (e.g., the maximum width) of the first deep well region 161 along the first direction (X direction). For example, the width of the second shield layer 320 in the first direction (X direction) may be greater than or equal to the distance in the first direction (X direction) between adjacent gate trenches GT in the first direction (X direction). The width of the second shield layer 320 in the first direction (X direction) may be less than or equal to the distance in the first direction (X direction) between adjacent well regions 133 in the first direction (X direction). Here, the width of the second shield layer 320 along the first direction (X direction) may be the maximum width of the second shield layer 320 along the first direction (X direction). Accordingly, the second shield layer 320 may effectively alleviate the electric field generated around the gate electrode 150.

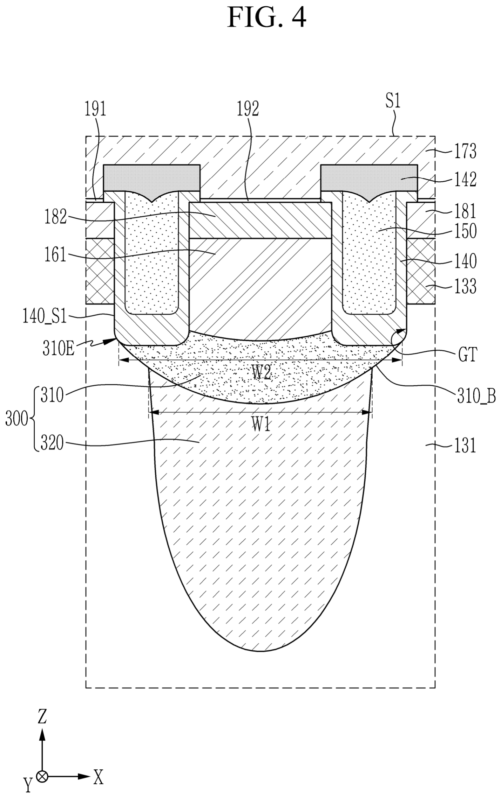

In an embodiment, the width (e.g., the maximum width) of the second shield layer 320 along the first direction (X direction) may be substantially the same as the width (e.g., the maximum width) of the first shield layer 310 along the first direction (X direction), but example embodiments are not limited thereto. Further explanation is illustrated in FIGS. 4 to 6.

The thickness of the second shield layer 320 along the third direction (Z direction) may be greater than the depth of the gate trench GT along the third direction (Z direction). The thickness of the second shield layer 320 along the third direction (Z direction) may be greater than the thickness of the well region 133 along the third direction (Z direction). The thickness of the second shield layer 320 along the third direction (Z direction) may be greater than the thickness of the first deep well region 161 along the third direction (Z direction). Accordingly, the second shield layer 320 may prevent the breakdown voltage of the transistor from decreasing due to an electric field generated by a voltage applied to the gate electrode 150. Here, the thickness of the second shield layer 320 along the third direction (Z direction) may be the maximum length of the second shield layer 320 along the third direction (Z direction), or the length in the Z direction between an uppermost surface (e.g., a highest portion of the uppermost surface in the Z direction) of the second shield layer 320 and a lowermost surface (e.g., a lowest portion of the lowermost surface in the Z direction) of the second shield layer 320.

The lower surface 320_B of the second shield layer 320 may include a convex curved surface toward the drain electrode 175. For example, the lower surface 320_B of the second shield layer 320 may have a convex shape toward the first surface 110a of the substrate 110. The lower surface 320_B of the second shield layer 320 may protrude towards the first surface 110a of the substate 110. In this case, the curvature of the lower surface 320_B of the second shield layer 320 may be greater than or equal to the curvature of the lower surface 310_B of the first shield layer 310. This may be due to the process characteristics of forming the first shield layer 310 using a random ion implantation process within the epitaxial layer 131, while forming the second shield layer 320 using a channeling ion implantation process and/or a high energy implant process within the epitaxial layer 131.

The second shield layer 320 may be a doped region formed using an ion implantation process within the epitaxial layer 131. For example, the second shield layer 320 may be formed using a channeling ion implantation process and/or a high energy implant process. Accordingly, ions may be injected from the upper surface of the epitaxial layer 131 to a deep region (e.g., into the body of the epitaxial layer 131) to form a second shield layer 320 of a semiconductor device according to an embodiment. The second shield layer 320 may have a second conductivity type. The second shield layer 320 may be doped with a second conductivity type. Here, the second conductivity type may be p-type, but example embodiments are not limited thereto. In an embodiment, the doping concentration of the second shield layer 320 may be different from the doping concentration of the first shield layer 310, but example embodiments are not limited thereto.

According to an embodiment, the second shield layer 320 of the semiconductor device may have a second conductivity type, and the epitaxial layer 131 may have a first conductivity type. Accordingly, a semiconductor device according to an embodiment may form a PN junction interface at the interface IF between the lower surface 320_B of the second shield layer 320 and the epitaxial layer 131, and may perform the function of a diode device.

The drain electrode 175 may be positioned on the second surface 110b, i.e., the lower surface, of the substrate 110. The upper surface of the drain electrode 175 may be in contact with the lower surface of the substrate 110. The drain electrode 175 may be in ohmic contact with the substrate 110. The region in contact with the drain electrode 175 within the substrate 110 may be doped at a relatively high concentration compared to other regions. However, example embodiments are not limited thereto, and another layer may be additionally positioned between the drain electrode 175 and the substrate 110. For example, a silicide layer may be further positioned between the drain electrode 175 and the substrate 110. The drain electrode 175 and the substrate 110 may be electrically connected (e.g., smoothly connected) by the silicide layer. For instance, the silicide layer may reduce the resistance between the drain electrode 175 and the substrate 110.

The drain electrode 175 may include a conductive material. For example, the drain electrode 175 may include a metal, a metal alloy, a conductive metal nitride, a metal silicide, a doped semiconductor material, a conductive metal oxide, or a conductive metal nitride. The drain electrode 175 may be made of the same material as the source electrode 173 or may be made of a different material. The drain electrode 175 may be formed of a single layer or multiple layers.

In an embodiment, the source electrode 173, the drain electrode 175, and the gate electrode 150 may form a transistor having the well region 133 as a channel region. According to an embodiment, a semiconductor device may enable carrier flow in a third direction (Z direction) from a source electrode 173 toward a drain electrode 175 when a turn-on signal is applied to the gate electrode 150. In this case, the carrier may flow from the source electrode 173 to the drain electrode 175 through the first doped layer 181, the well region 133, the epitaxial layer 131, and the substrate 110.

The shield pattern 300 of a semiconductor device according to an embodiment may be positioned between the first deep well region 161 and the epitaxial layer 131. Additionally, the second deep well region 162 may be positioned on one side of the well region 133. The second deep well region 162 and/or the shield pattern 300 may prevent the breakdown voltage of the transistor from being reduced due to an electric field generated by a voltage applied to the gate electrode 150. Accordingly, the reliability of a semiconductor device according to an embodiment may be improved.

A semiconductor device according to an embodiment may be an n-type field effect transistor (n-FET). However, example embodiments are not limited thereto, and the semiconductor device according to an embodiment may be a p-type field effect transistor (p-FET). In this case, the substrate 110, the epitaxial layer 131, and the first doped layer 181 may have the second conductivity type (e.g., p-type), and the well region 133, the first deep well region 161, the second deep well region 162, and the shield pattern 300 may have the first conductivity type (e.g., n-type).

According to an embodiment, the semiconductor device has been described as having a structure in which the gate electrode 150 is positioned within the gate trench GT and the source electrode 173 is positioned at a higher layer than the gate electrode 150, but example embodiments are not limited thereto. For example, a semiconductor device according to some embodiments may have a gate electrode 150 positioned within a gate trench GT and a source electrode 173 positioned within a source trench located at one side of the gate trench GT. As another example, a semiconductor device according to some embodiments may have a gate electrode 150 positioned on the upper surface of an epitaxial layer 131, and a source electrode 173 positioned on a side surface of the gate electrode 150 above the epitaxial layer 131. As another example, a semiconductor device according to some embodiments may include a Si IGBT (Insulated Gate Bipolar Transistor) structure. As another example, a semiconductor device according to some embodiments may include a superjunction structure in which the p-type region and the n-type region are entirely depleted, thereby forming a two-dimensional uniform electric field distribution.

Hereinafter, semiconductor devices according to some embodiments will be described with reference to FIGS. 4 to 17.

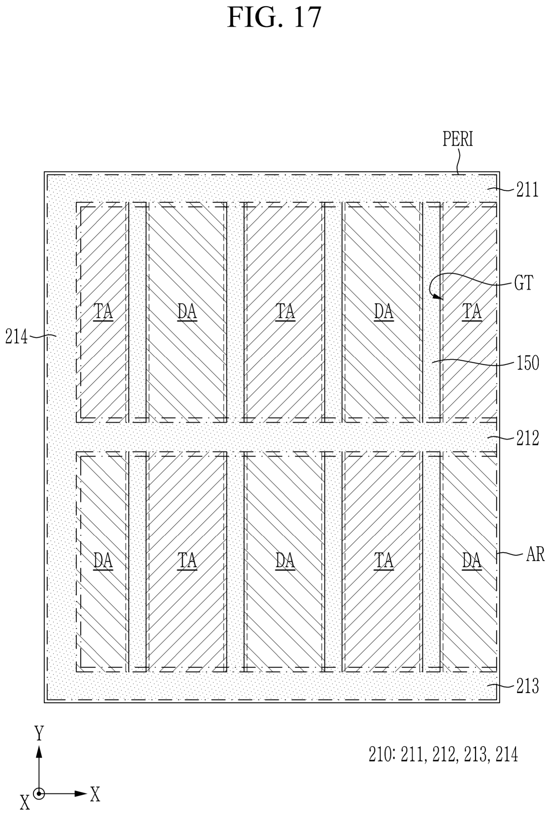

FIGS. 4 to 17 are cross-sectional views corresponding to area S1 of FIG. 2, showing semiconductor devices according to some embodiments. FIG. 17 is a plan view illustrating a semiconductor device according to some embodiments.

FIGS. 4 to 17 illustrate various modified examples of semiconductor devices according to an embodiment illustrated in FIGS. 1 to 3. The embodiments illustrated in FIGS. 4 to 17 are similar to the embodiments illustrated in FIGS. 1 to 3, therefore, only the differences will be explained below. Additionally, the same drawing symbols are used for the same components as in the previous embodiment.

Referring to FIG. 4, the first shield layer 310 of the semiconductor device according to some embodiments may entirely cover the lower surface (e.g., lowermost surface) of the gate trench GT.

In some embodiments, the first shield layer 310 may be positioned on a lower surface of the gate trench GT. The edge 310E of the first shield layer 310 may be aligned with the inner side wall of the gate trench GT. For example, the edge 310E of the first shield layer 310 may be aligned with one side 140_S1 of the gate insulating layer 140. The first shield layer 310 may entirely cover the lower surface of the gate insulating layer 140 (e.g., of two adjacent gate insulating layers 140). The lower surface (e.g., lowermost surface) of the gate insulating layer 140 may be positioned apart from the epitaxial layer 131. The lower surface 310_B of the first shield layer 310 may be in contact with the epitaxial layer 131 and the second shield layer 320. Accordingly, the shield pattern 300 of the semiconductor device according to an embodiment may effectively alleviate the electric field generated around the gate electrode 150.

In some embodiments, the width W1 (e.g., a maximum width) of the second shield layer 320 along the first direction (X direction) may be different from the width W2 (e.g., a maximum width) of the first shield layer 310 along the first direction (X direction). For example, the width W2 of the first shield layer 310 along the first direction (X direction) may be larger than the width W1 of the second shield layer 320 along the first direction (X direction).

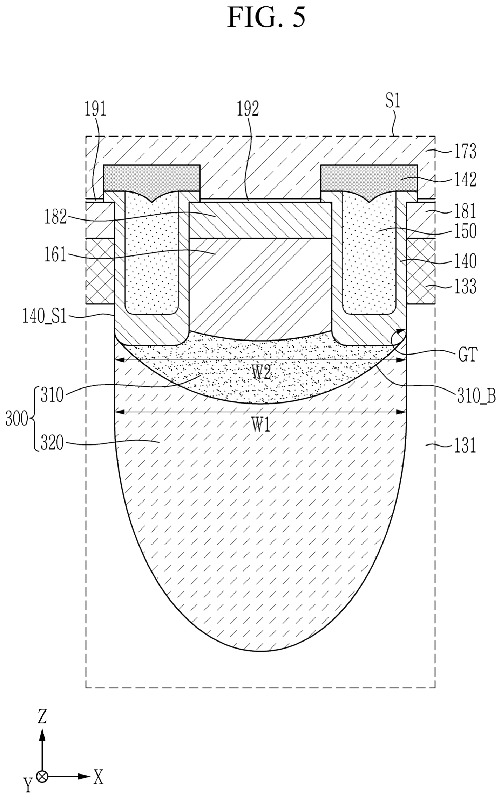

Referring to FIG. 5, a shield pattern 300 of a semiconductor device according to some embodiments may entirely cover a lower surface of a gate insulating layer 140.

In some embodiments, the first shield layer 310 may entirely cover the lower surface of the gate insulating layer 140 (e.g., of two adjacent gate insulating layers 140), and the second shield layer 320 may entirely cover the lower surface of the first shield layer 310. Accordingly, the lower surface (e.g., lowermost surface) of the gate insulating layer 140 may be spaced apart from the epitaxial layer 131.

In some embodiments, the edge of the first shield layer 310 and the edge of the second shield layer 320 may be aligned with the inner side wall of the gate trench GT. For example, the edge of the first shield layer 310 and the edge of the second shield layer 320 may be aligned with one side 140_S1 of the gate insulating layer 140. In some embodiments, the width W2 (e.g., a maximum width) of the first shield layer 310 along the first direction (X direction) may be substantially equal to the width W1 (e.g., a maximum width) of the second shield layer 320 along the first direction (X direction). Accordingly, the shield pattern 300 of the semiconductor device according to an embodiment may effectively alleviate the electric field generated around the gate electrode 150.

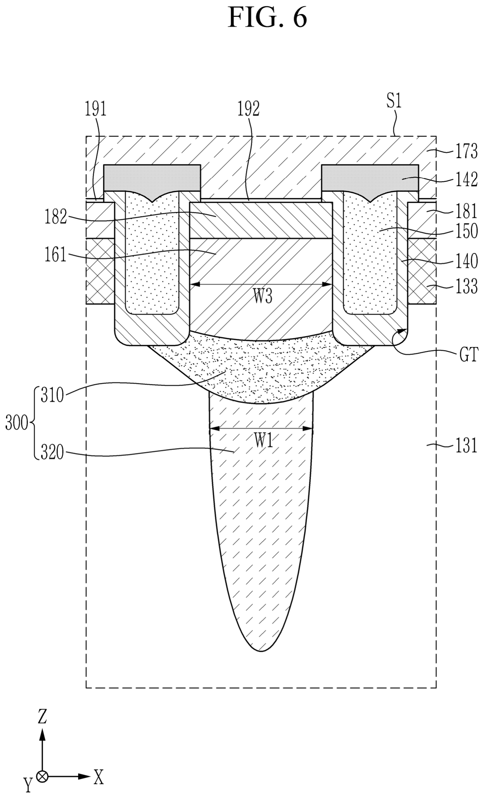

Referring to FIG. 6, a width W1 (e.g., a maximum width) of a second shield layer 320 of a semiconductor device according to some embodiments along a first direction (X direction) may be smaller than a width W3 (e.g., maximum width) of a first deep well region 161 along the first direction (X direction). In some embodiments, the second shield layer 320 may overlap the first deep well region 161 in the third direction (Z direction) and does not overlap the gate trench GT in the third direction (Z direction). For example, the second shield layer 320 does not overlap with the gate electrode 150 and the gate insulating layer 140 in the third direction (Z direction). Even in this case, since the first shield layer 310 is positioned between the first deep well region 161 and the second shield layer 320, and also between the gate insulating layer 140 and the second shield layer 320, and is formed with a width sufficient to cover at least a portion of the lower surface of the gate insulating layer 140, the shield pattern 300 of the semiconductor device according to an embodiment may effectively alleviate the electric field generated around the gate electrode 150.

Referring to FIG. 7, a first shield layer 310 of a semiconductor device according to some embodiments may overlap a gate electrode 150 in the horizontal direction (first direction (X direction) and/or second direction (Y direction)). In some embodiments, the upper surface of the first shield layer 310 may be located at a higher level than the lower surface of the gate electrode 150. The upper surface of the first shield layer 310 may be located further from the first surface 110a of the substrate 110 than the lower surface of the gate electrode 150 is from the first surface 110a of the substrate 110.

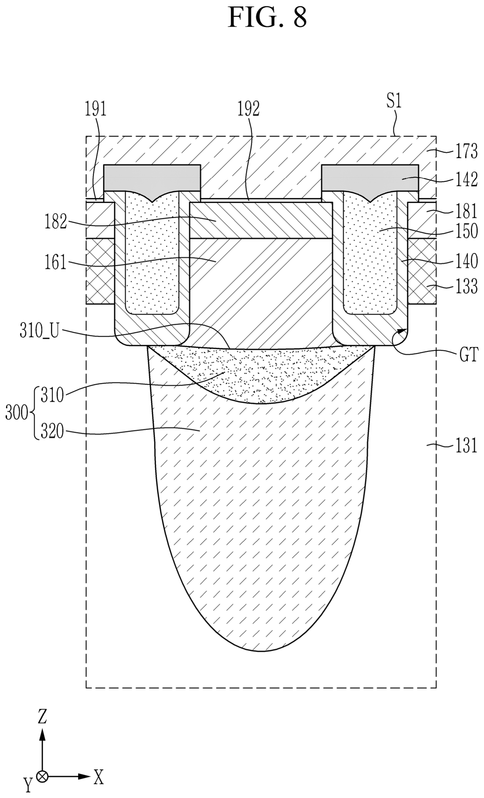

Referring to FIG. 8, the first shield layer 310 of the semiconductor device according to some embodiments does not overlap with the gate trench GT in the horizontal direction (first direction (X direction) and/or second direction (Y direction)). In some embodiments, the upper surface 310_U of the first shield layer 310 may be located at a lower level than the lower surface of the gate electrode 150. The upper surface 310_U of the first shield layer 310 may be positioned closer to the first surface 110a of the substrate 110 than the lower surface of the gate electrode 150 is to the first surface 110a of the substrate 110. In some embodiments, the upper surface 310_U of the first shield layer 310 does not overlap with the gate insulating layer 140 or the gate electrode 150 in the horizontal direction (first direction (X direction) and/or second direction (Y direction)). The upper surface 310_U of the first shield layer 310 may be flat, but example embodiments are not limited thereto.

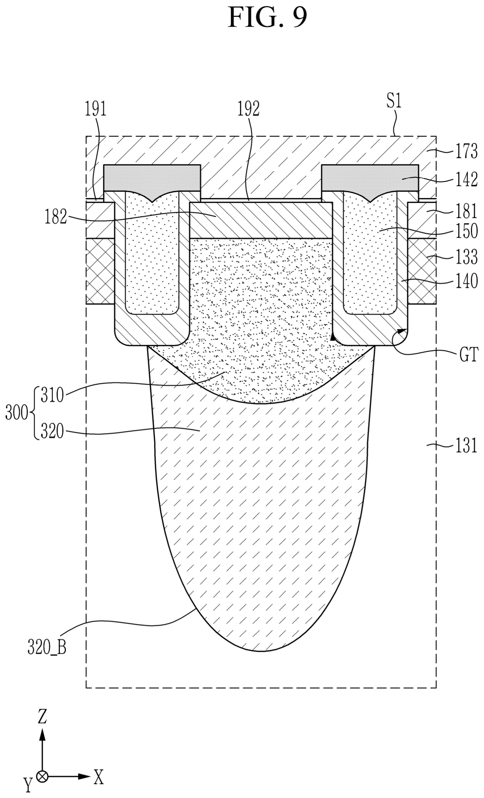

Referring to FIG. 9, a semiconductor device according to some embodiments may not include a first deep well region 161. In some embodiments, the first shield layer 310 may be positioned between adjacent gate trenches GT in the first direction (X direction). The second doped layer 182 may be positioned on the first shield layer 310. The second doped layer 182 may be in contact with the first shield layer 310.

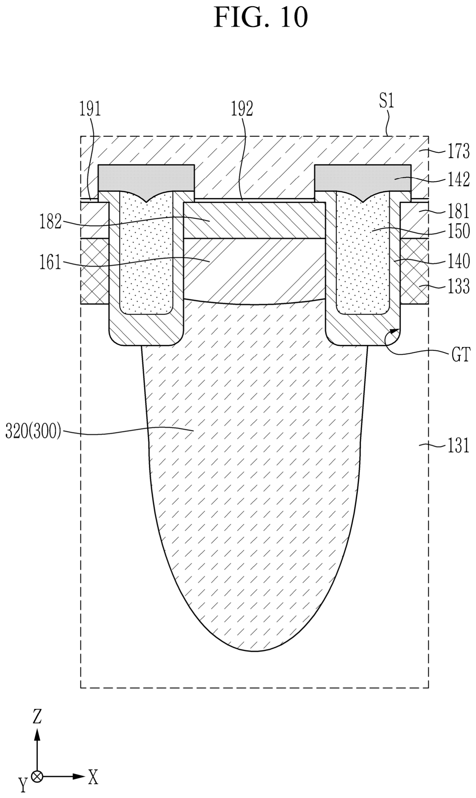

Referring to FIG. 10, a shield pattern 300 of a semiconductor device according to some embodiments may be formed of a single layer. In some embodiments, the shield pattern 300 may be formed solely of the second shield layer 320, but example embodiments are not limited thereto.

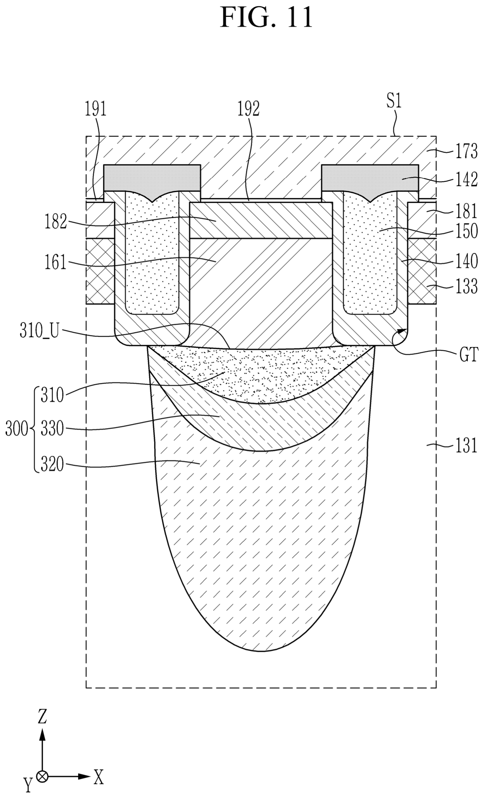

Referring to FIG. 11, a shield pattern 300 of a semiconductor device according to some embodiments may further include a third shield layer 330 positioned between the first shield layer 310 and the second shield layer 320.

The third shield layer 330 may be positioned between the first shield layer 310 and the second shield layer 320. The third shield layer 330 may overlap the first deep well region 161, the gate electrode 150, and the gate insulating layer 140 in the third direction (Z direction). The third shield layer 330 does not overlap with the well region 133 in the third direction (Z direction).

In some embodiments, the width of the third shield layer 330 along the first direction (X direction) may be substantially the same as the width of the first shield layer 310 along the first direction (X direction) and/or the width of the second shield layer 320 along the first direction (X direction), but the embodiments are not limited thereto.

In some embodiments, the lower surface of the third shield layer 330 may include a convex curved surface toward the drain electrode 175. For example, the lower surface of the third shield layer 330 may have a convex shape toward the first surface 110a of the substrate 110. For example, the lower surface of the third shield layer 330 may protrude towards the first surface 110a of the substrate 110. In this case, the curvature of the lower surface of the third shield layer 330 may be greater than or equal to the curvature of the lower surface 310_B of the first shield layer 310. The curvature of the lower surface of the third shield layer 330 may be smaller than or equal to the curvature of the lower surface 320_B of the second shield layer 320.

The third shield layer 330 may be a doped region formed using an ion implantation process within the epitaxial layer 131. For example, the third shield layer 330 may be formed using a channeling ion implantation process and/or a high energy implant process. As another example, the third shield layer 330 may be formed using a random ion implantation process. The third shield layer 330 may have a second conductivity type. The third shield layer 330 may be doped with a second conductivity type. Here, the second conductivity type may be p-type, but example embodiments are not limited thereto. In an embodiment, the doping concentration of the third shield layer 330 may be different from the doping concentration of the first shield layer 310 and/or the doping concentration of the second shield layer 320, but example embodiments are not limited thereto.

Referring to FIGS. 12 and 13, the gate insulating layer 140 of the semiconductor device according to some embodiments may have various shapes.

In some embodiments, the gate insulating layer 140 may include an edge 140E. The edge 140E of the gate insulating layer 140 may mean a portion where the lower surface of the gate insulating layer 140 and the side surface of the gate insulating layer 140 meet.

In some embodiments, the gate electrode 150 may have a different shape than the gate trench GT. Accordingly, the third thickness TH3 between the edge 140E of the gate insulating layer 140 and the gate electrode 150 may be different from the first thickness TH1 along the third direction (Z direction) of the gate insulating layer 140. For example, as illustrated in FIG. 12, the third thickness TH3 between the edge 140E of the gate insulating layer 140 and the gate electrode 150 may be greater than the first thickness TH1 of the gate insulating layer 140 along the third direction (Z direction). In this case, the third thickness TH3 between the edge 140E of the gate insulating layer 140 and the gate electrode 150 may be greater than the second thickness TH2 of the gate insulating layer 140 along the first direction (X direction). As another example, as illustrated in FIG. 13, the third thickness TH3 between the edge 140E of the gate insulating layer 140 and the gate electrode 150 may be smaller than the first thickness TH1 of the gate insulating layer 140 along the third direction (Z direction). In this case, the third thickness TH3 between the edge 140E of the gate insulating layer 140 and the gate electrode 150 may be greater than the second thickness TH2 of the gate insulating layer 140 along the first direction (X direction).

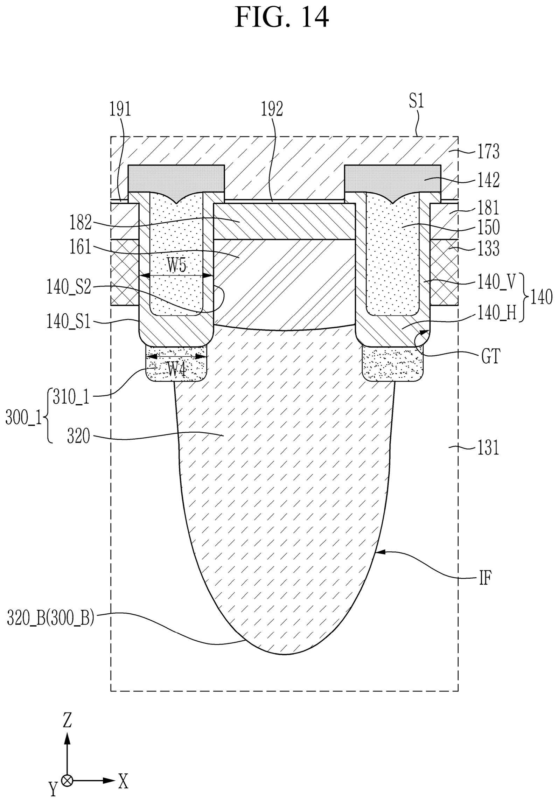

Referring to FIGS. 14 to 16, the first shield layer 310_1 of the semiconductor device according to some embodiments may have various shapes.

Referring to FIG. 14, the first shield layer 310_1 may be positioned under the gate trench GT. The first shield layer 310_1 may be positioned between the gate trench GT and the epitaxial layer 131 and between the gate trench GT and the second shield layer 320. The first shield layer 310_1 may protrude from the bottom surface of the gate trench GT toward the first surface 110a of the substrate 110. The first shield layer 310_1 may be positioned between the gate insulating layer 140 and the epitaxial layer 131 and between the gate insulating layer 140 and the second shield layer 320. The first shield layer 310_1 may protrude from the lower surface of the gate insulating layer 140 toward the first surface 110a of the substrate 110.

The first shield layer 310_1 may overlap the gate trench GT in the third direction (Z direction). For example, the entirety of the first shield layer 310_1 may overlap the gate trench GT in the third direction (Z direction), but example embodiments are not limited thereto. The first shield layer 310_1 may overlap the gate electrode 150 and the gate insulating layer 140 in the third direction (Z direction). In one embodiment, the first shield layer 310_1 does not overlap with the first deep well region 161 or the well region 133 in the third direction (Z direction). At least a portion of the first shield layer 310_1 may overlap the second shield layer 320 in the third direction (Z direction). For example, a part of the first shield layer 310_1 may overlap the second shield layer 320 in the third direction (Z direction), and the remaining part may overlap the epitaxial layer 131 in the third direction (Z direction) without overlapping the second shield layer 320 in the third direction (Z direction). The upper surface of the first shield layer 310_1 may be in contact with the gate insulating layer 140, but example embodiments are not limited thereto. The lower surface of the first shield layer 310_1 may be in contact with the second shield layer 320 and the epitaxial layer 131, but example embodiments are not limited thereto.

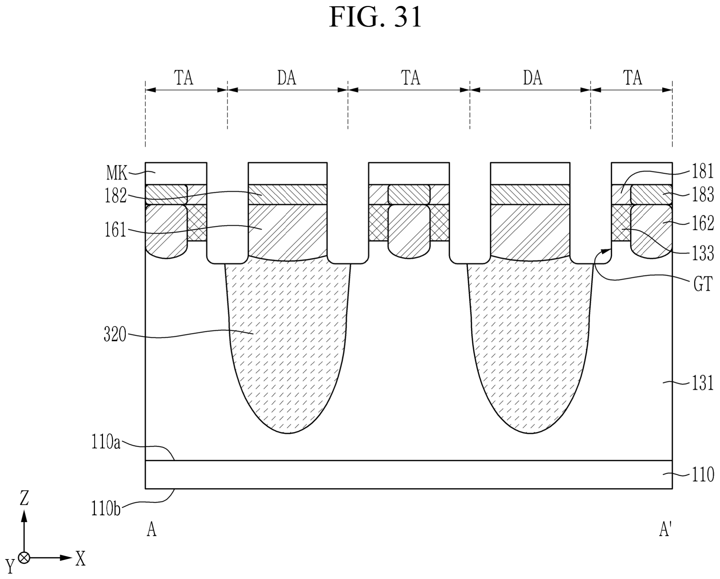

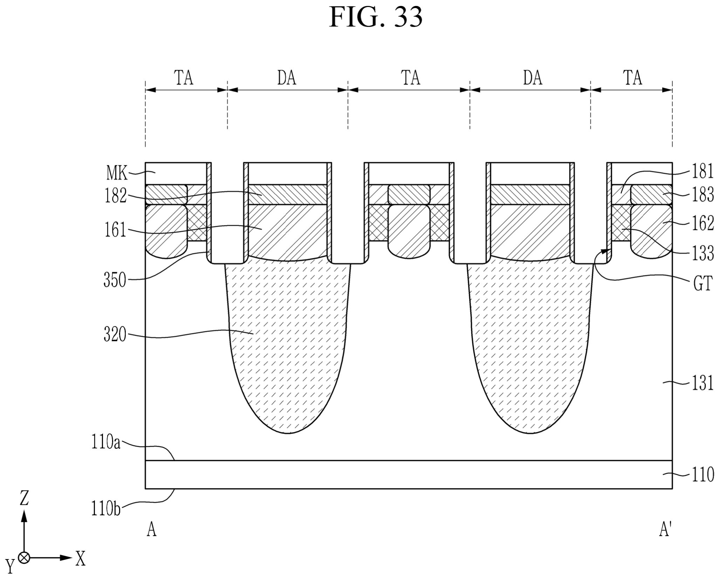

The width W4 of the first shield layer 310_1 along the first direction (X direction) may be smaller than the width W5 of the gate trench GT along the first direction (X direction). The width W4 of the first shield layer 310_1 along the first direction (X direction) may be smaller than the maximum width of the gate insulating layer 140 along the first direction (X direction). Here, the maximum width of the gate insulating layer 140 along the first direction (X direction) may be the distance along the first direction (X direction) between one side 140_S1 and the other side 140_S2 of the gate insulating layer 140. This may be due to the process characteristics of forming a first shield layer 310_1 by using a channeling ion implantation process and/or a high energy implant process on a portion of the epitaxial layer 131 exposed by the spacer (see 350 of FIG. 33), after forming a gate trench GT and forming a spacer (see 350 of FIG. 33) within the gate trench GT. Accordingly, even when the gate trench GT is formed so as not to overlap with the shield pattern 300_1 in the third direction (Z direction) due to misalignment, etc., the first shield layer 310_1 may be formed under the gate trench GT. Accordingly, the shield pattern 300 may prevent the breakdown voltage of the transistor from decreasing due to an electric field generated by a voltage applied to the gate electrode 150, and improve the reliability of the semiconductor device according to the embodiment. A detailed explanation of this will be provided later with reference to FIGS. 31 to 35. However, example embodiments are not limited thereto, and the width W4 of the first shield layer 310_1 along the first direction (X direction) may be greater than or equal to the width W5 of the gate trench GT along the first direction (X direction).

The second shield layer 320 may be located below the first deep well region 161. The upper surface of the second shield layer 320 may be in contact with the first deep well region 161, but example embodiments are not limited thereto.

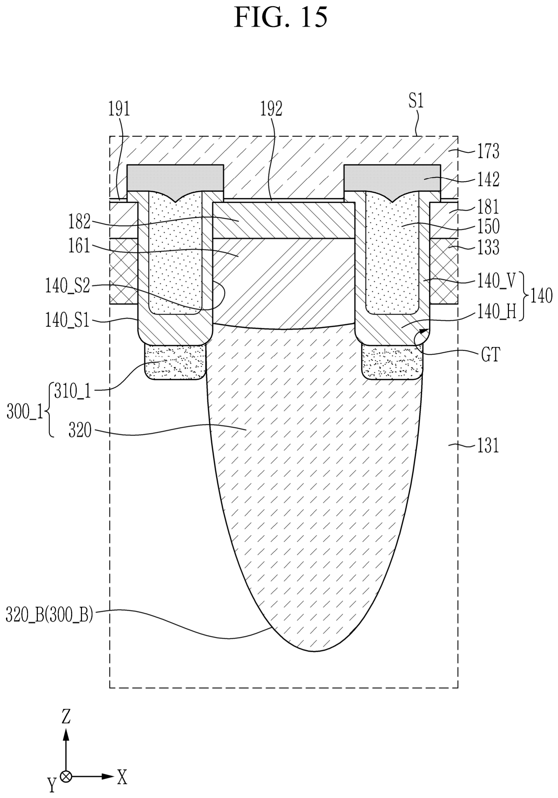

Referring to FIG. 15, the first shield layer 310_1 does not overlap the second shield layer 320 in the third direction (Z direction). For example, a semiconductor device according to some embodiments may include a plurality of gate trenches GT spaced apart from each other in a first direction (X direction), and a plurality of first shield layers 310_1 positioned beneath each of the plurality of gate trenches GT. At least one first shield layer 310_1 among the plurality of first shield layers 310_1 may not overlap with the second shield layer 320 in the third direction (Z direction). In Fig. 15, the side of the first shield layer 310_1 is depicted as being in contact with the side of the second shield layer 320, but example embodiments are not limited thereto. As another example, the first shield layer 310_1 may be positioned spaced apart from the second shield layer 320 in the first direction (X direction).

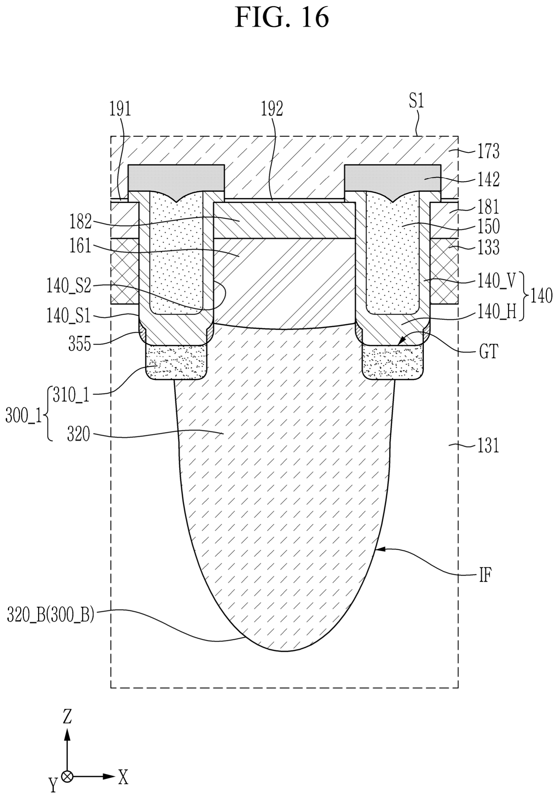

Referring to FIG. 16, a semiconductor device according to some embodiments may further include a dummy pattern 355 positioned within a gate trench GT.

The dummy pattern 355 may be positioned on the bottom surface and/or inner side wall of the gate trench GT. For example, the dummy pattern 355 may be located at the edge of the gate trench GT where the bottom surface and the inner side wall of the gate trench GT meet. The dummy pattern 355 may be positioned between the gate insulating layer 140 and the epitaxial layer 131. The dummy pattern 355 may be spaced apart from the first shield layer 310_1. For example, the dummy pattern 355 may be spaced apart from the first shield layer 310_1 in the first direction (X direction). Additionally, the dummy pattern 355 may be spaced apart from the first shield layer 310_1 in the third direction (Z direction). The dummy pattern 355 may not overlap with the first shield layer 310_1 in the third direction (Z direction). Additionally, the dummy pattern 355 may not overlap with the first shield layer 310_1 in the first direction (X direction). The dummy pattern 355 may not overlap with the well region 133 in the first direction (X direction), but example embodiments are not limited thereto. The upper surface of the dummy pattern 355 may be located at a lower level than the lower surface of the well region 133. The upper surface of the dummy pattern 355 may be positioned closer to the first surface 110a of the substrate 110 than the lower surface of the well region 133 is to the first surface 110a of the substrate 110.

The dummy pattern 355 may be a pattern in which at least a portion of the spacer (see 350 of FIG. 33) remains unremoved during the process of removing the spacer (see 350 of FIG. 33) located within the gate trench GT. The dummy pattern 355 may include various insulating materials. The dummy pattern 355 may include the same material as the gate insulating layer 140, but example embodiments are not limited thereto. For example, the dummy pattern 355 may include SiO₂. When the dummy pattern 355 is made of the same material as the gate insulating layer 140, the boundary between the dummy pattern 355 and the gate insulating layer 140 may not be clearly distinguishable at the region where they come into contact.

Referring to FIG. 17, the transistor area TA and the diode area DA located in the active area AR of the semiconductor device according to some embodiments may be arranged in various ways. For example, the active area AR of a semiconductor device according to some embodiments may include a first active area AR positioned between the first portion 211 and the second portion 212 of the gate frame 210 and a second active area AR positioned between the second portion 212 and the third portion 213 of the gate frame 210. The first active area AR may have the transistor area TA and the diode area DA alternately positioned along the first direction (X direction), and the second active area AR may have the diode area DA and the transistor area TA alternately positioned along the first direction (X direction). The transistor area TA of the first active area AR and the diode area DA of the second active area AR may overlap along the second direction (Y direction), and the diode area DA of the first active area AR and the transistor area TA of the second active area AR may overlap along the second direction (Y direction), but example embodiments are not limited thereto.

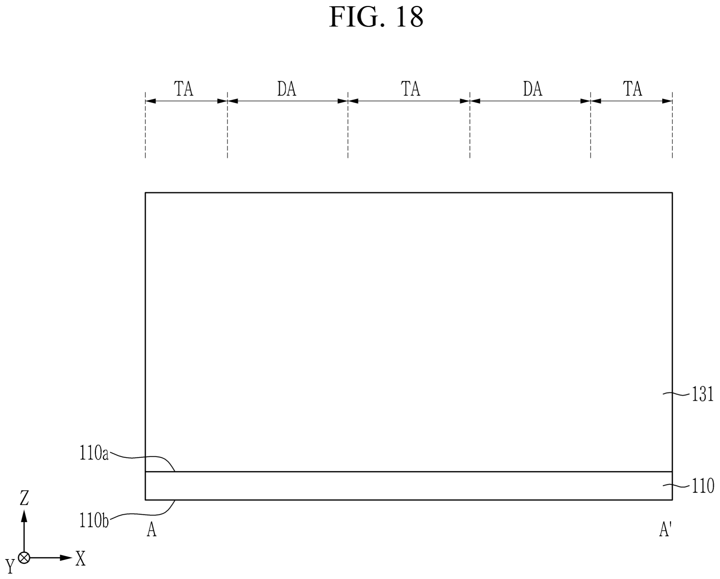

Hereinafter, a method for manufacturing a semiconductor device according to an embodiment will be described with reference to FIGS. 18 to 30.

FIGS. 18 to 30 are cross-sectional views corresponding to A-A' of FIG. 1, showing a method for manufacturing a semiconductor device according to an embodiment.

Referring to FIG. 18, an epitaxial layer 131 is formed on a substrate 110.

The substrate 110 may be a semiconductor substrate including SiC. For example, the substrate 110 may be made of a 4H SiC substrate. In some cases, the substrate 110 may be made of a 3C SiC substrate, a 6H SiC substrate, etc. The substrate 110 may have a first conductivity type. The substrate 110 may be heavily doped with the first conductivity type. The first conductivity type may be n-type, but is not limited thereto. The resistivity of the substrate 110 may be about 0.005Ωcm or more and about 0.035Ωcm or less (e.g., greater than or equal to 0.005Ωcm and less than or equal to 0.035Ωcm). The thickness of the substrate 110 may be about 10 µm or more and about 700 µm or less (e.g., greater than or equal to 10 µm and less than or equal to 700 µm). The material, doping type, doping concentration, resistivity, thickness, etc. of the substrate 110 are not limited thereto and may be changed in various ways.

The substrate 110 may include a transistor area TA and a diode area DA. The transistor area TA and the diode area DA may be positioned alternately along the first direction (X direction). The transistor area TA may be a region where an n-type field effect transistor (n-FET) is formed, and the diode area DA may be a region where a diode element is formed. However, example embodiments are not limited thereto, and a p-type field effect transistor may be formed in the transistor area TA.

The substrate 110 may include a first surface 110a and a second surface 110b opposing (e.g., opposite to) each other. The first surface 110a of the substrate 110 may be the upper surface of the substrate 110, and the second surface 110b of the substrate 110 may be the lower surface of the substrate 110.

An epitaxial layer 131 may be formed on the first surface 110a of the substrate 110. The lower surface of the epitaxial layer 131 may be in contact with the first surface 110a of the substrate 110. However, example embodiments are not limited thereto, and another layer may be additionally positioned between the substrate 110 and the epitaxial layer 131. The epitaxial layer 131 may be an epitaxial layer formed from a substrate 110 using an epitaxial growth method.

In an embodiment, the crystal plane of the material comprising the epitaxial layer 131 may be formed at a predetermined angle with respect to the first surface 110a of the substrate 110. For example, the crystal plane of the material comprising the epitaxial layer 131 may be tilted by about 4° from the first surface 110a of the substrate 110. For example, when the epitaxial layer 131 includes SiC, the (0001) crystal plane of SiC may be tilted by about 4° from the first surface 110a of the substrate 110. Accordingly, in the process of forming an epitaxial layer 131 using an epitaxial growth method, lattice distortion due to dislocations or the like within the epitaxial layer 131 may be prevented.

The epitaxial layer 131 may include SiC. For example, the epitaxial layer 131 may include 4H SiC. The epitaxial layer 131 may have a first conductivity type. The epitaxial layer 131 may be lightly doped with a first conductivity type. The first conductivity type may be n-type, but is not limited thereto.

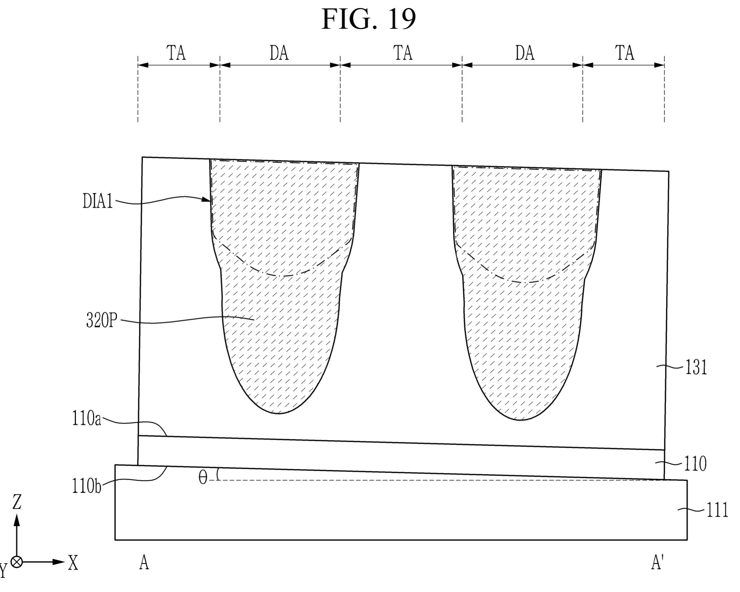

Referring to FIG. 19, a second preliminary shield layer 320P is formed within the epitaxial layer 131 in the diode area DA. The second preliminary shield layer 320P may be a doped region formed using an ion implantation process within the epitaxial layer 131. For example, a second preliminary shield layer 320P may be formed using a channeling ion implantation process and/or a high energy implant process within the epitaxial layer 131.

Specifically, a semiconductor element may be positioned on a support 111. The support 111 may be a carrier substrate, or may be a support for performing a channeling ion implantation process and/or a high energy implant process. The upper surface of the support 111 may be inclined at a predetermined angle θ. The angle θ at which the upper surface of the support 111 is tilted may be substantially the same as the angle at which the crystal plane of the material comprising the above-described epitaxial layer 131 is tilted from the first surface 110a of the substrate 110. The angle θ at which the upper surface of the support 111 is inclined may be about 4°, but example embodiments are not limited thereto. Accordingly, the semiconductor element may be rotated at a predetermined angle θ.

In order to perform a channeling ion implantation process and/or a high energy implant process, the lattice direction of the elements comprising the epitaxial layer 131 needs to be aligned in a predetermined direction. As the support 111 is tilted at a predetermined angle θ, the crystal plane of the material comprising the epitaxial layer 131 may be aligned, and a channeling ion implantation process and/or a high energy implant process may be performed within the epitaxial layer 131 to deeply form a second preliminary shield layer 320P. The second preliminary shield layer 320P may have a second conductivity type. The second preliminary shield layer 320P may be doped with a second conductivity type. The second conductivity type may be p-type, but is not limited thereto.

The lower surface of the second preliminary shield layer 320P may include a convex curved surface toward the first surface 110a of the substrate 110. For example, the lower surface of the second preliminary shield layer 320P may have a convex shape toward the first surface 110a of the substrate 110. This may be due to the process characteristics of forming a shield pattern 300 using a channeling ion implantation process and/or a high energy implant process within the epitaxial layer 131.

In this case, a first dummy region DIA1 may be formed on the upper side of the epitaxial layer 131 by forming a second preliminary shield layer 320P using a channeling ion implantation process and/or a high energy implant process. The first dummy region DIA1 may be an area formed due to injection of a small amount of ions into the upper portion of the epitaxial layer 131 during the formation of the second preliminary shield layer 320P. The first dummy region DIA1 may be largely undoped or lightly doped. The doping concentration of the first dummy region DIA1 may be lower than the doping concentration of the second preliminary shield layer 320P. The first dummy region DIA1 may correspond to an area where a first preliminary shield layer 310P is formed later, but example embodiments are not limited thereto.

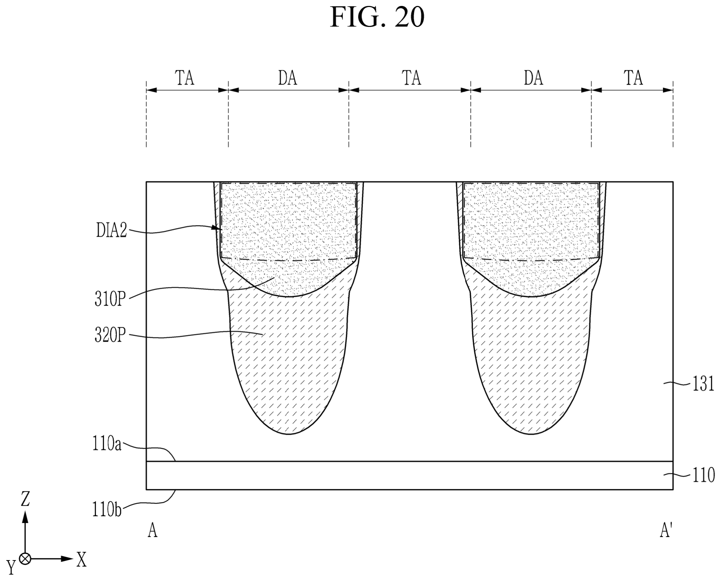

Referring to FIG. 20, after a semiconductor element tilted at a predetermined angle θ is rotated back to its original position, a first preliminary shield layer 310P overlapping a second preliminary shield layer 320P in a third direction (Z direction) may be formed within the epitaxial layer 131.

In an embodiment, in the diode area DA, a first preliminary shield layer 310P overlapping the second preliminary shield layer 320P in the third direction (Z direction) may be formed using an ion implantation process within the epitaxial layer 131. The process of forming the first preliminary shield layer 310P may be performed using a random ion implantation process. The first preliminary shield layer 310P may be a doped region formed using an ion implantation process within the epitaxial layer 131. For example, a first preliminary shield layer 310P may be formed using an ion implantation process within the first dummy region DIA1. The first preliminary shield layer 310P may have a second conductivity type. The first preliminary shield layer 310P may be doped with the second conductivity type. The second conductivity type may be p-type, but is not limited thereto. The doping concentration of the first preliminary shield layer 310P may be different from the doping concentration of the second preliminary shield layer 320P, but example embodiments are not limited thereto.

The lower surface of the first preliminary shield layer 310P may include a convex curved surface toward the first surface 110a of the substrate 110. For example, the lower surface of the first preliminary shield layer 310P may have a convex shape toward the first surface 110a of the substrate 110. In this case, the curvature of the lower surface of the second preliminary shield layer 320P may be greater than or equal to the curvature of the lower surface of the first preliminary shield layer 310P. This may be due to the process characteristics of forming the first preliminary shield layer 310P using a random ion implantation process within the epitaxial layer 131, while forming the second preliminary shield layer 320P using a channeling ion implantation process and/or a high energy implant process within the epitaxial layer 131.

In this case, by forming the first preliminary shield layer 310P using an ion injection process, a second dummy region DIA2 may be formed on the upper portion of the epitaxial layer 131. The second dummy region DIA2 may be an area formed by injecting a small amount of ions into the upper portion of the epitaxial layer 131 during the formation of the first preliminary shield layer 310P. The second dummy region DIA2 may be largely undoped or lightly doped. The doping concentration of the second dummy region DIA2 may be lower than the doping concentration of the first preliminary shield layer 310P. The second dummy region DIA2 may correspond to the area where the first deep well region 161 is formed later, but example embodiments are not limited thereto.

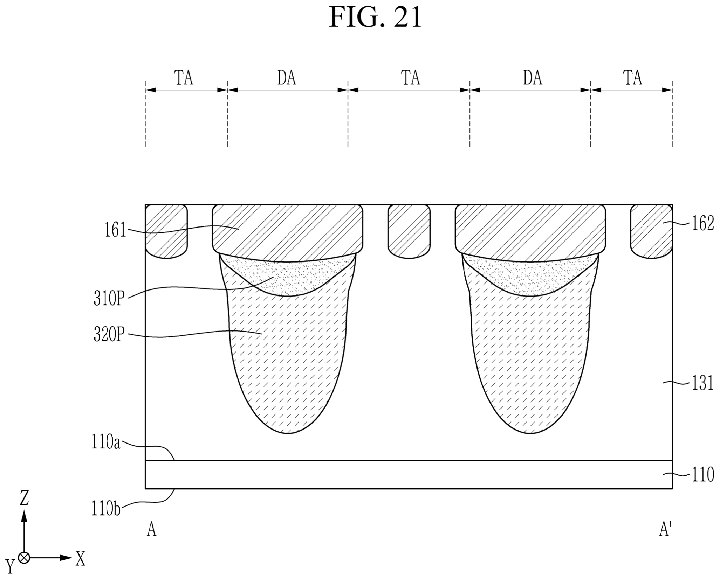

Referring to FIG. 21, a first deep well region 161 is formed within an epitaxial layer 131 that overlaps a first preliminary shield layer 310P in the third direction (Z direction).

In the diode area DA, an ion implantation process may be performed to form a first deep well region 161 within the second dummy region DIA2 of the first preliminary shield layer 310P. In this case, a first deep well region 161 may be formed together in a part of the first dummy region DIA1 of the second preliminary shield layer 320P and a part of the epitaxial layer 131. The first deep well region 161 may have a predetermined depth. The first deep well region 161 may overlap the first preliminary shield layer 310P and the second preliminary shield layer 320P in the third direction (Z direction).

The first deep well region 161 may have a second conductivity type. The first deep well region 161 may be doped with a second conductivity type. The second conductivity type may be p-type, but is not limited thereto. The doping concentration of the first deep well region 161 may be less than or equal to the doping concentration of the first preliminary shield layer 310P and the doping concentration of the second preliminary shield layer 320P. Accordingly, the breakdown voltage of the transistor may be prevented from decreasing due to an electric field generated by a voltage applied to the gate electrode 150. The material, doping type, doping concentration, thickness, etc. of the first deep well region 161 are not limited thereto and may be changed in various ways.

Additionally, a second deep well region 162 may be further formed within the epitaxial layer 131.

In the transistor area TA, an ion implantation process may be performed to form a second deep well region 162 within the epitaxial layer 131. The second deep well region 162 may have a predetermined depth. The thickness along the third direction (Z direction) of the second deep well region 162 may be substantially the same as the thickness along the third direction (Z direction) of the first deep well region 161, but example embodiments are not limited thereto. The second deep well region 162 does not overlap with the first preliminary shield layer 310P or the second preliminary shield layer 320P in the third direction (Z direction).

The second deep well region 162 may have a second conductivity type. The second deep well region 162 may be doped with a second conductivity type. The second conductivity type may be p-type, but not limited thereto. The doping concentration of the second deep well region 162 may be substantially the same as the doping concentration of the first deep well region 161, but example embodiments are not limited thereto. The doping concentration of the second deep well region 162 may be less than or equal to the doping concentration of the first preliminary shield layer 310P and the doping concentration of the second preliminary shield layer 320P. The material, doping type, doping concentration, thickness, etc. of the second deep well region 162 are not limited thereto and may be changed in various ways.

In Fig. 21, the first deep well region 161 and the second deep well region 162 are depicted as being positioned spaced apart from each other along the first direction (X direction), but this is not limited thereto. For example, the first deep well region 161 and the second deep well region 162 may be positioned adjacent to each other. Alternatively, the side of the first deep well region 161 may be in contact with the second deep well region 162.

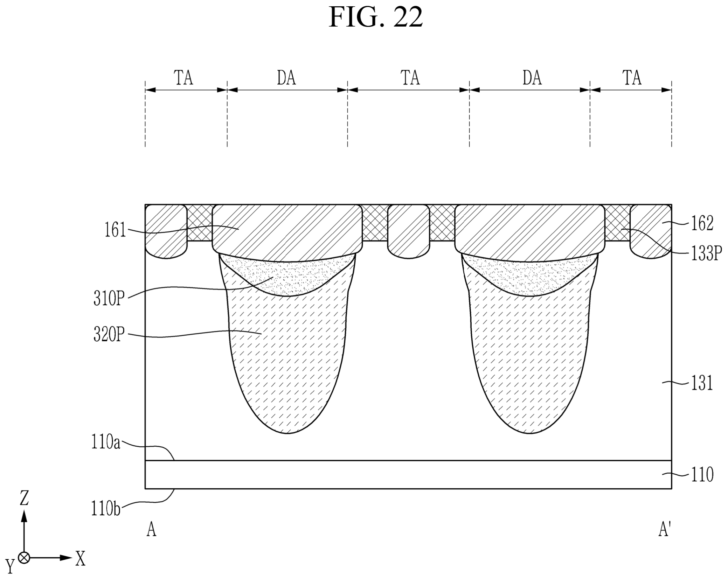

Referring to FIG. 22, a preliminary well region 133P may be formed on at least one side of the first deep well region 161. For example, in the transistor area TA, the preliminary well region 133P may be formed within the epitaxial layer 131 using an ion implantation process. The preliminary well region 133P may be positioned on opposite sides of the second deep well region 162.

The lower surface of the preliminary well region 133P may be positioned at a higher level than the lower surface of the second deep well region 162. The lower surface of the preliminary well region 133P may be positioned further from the first surface 110a of the substrate 110 than the lower surface of the second deep well region 162 is from the first surface 110a of the substrate 110. The upper surface of the preliminary well region 133P may be positioned at substantially the same level as the upper surface of the second deep well region 162, but example embodiments are not limited thereto. In an embodiment, the thickness of the preliminary well region 133P in the third direction (Z direction) may be smaller than the thickness of the second deep well region 162 in the third direction (Z direction). Accordingly, the breakdown voltage of the transistor may be prevented from decreasing due to an electric field generated by a voltage applied to the gate electrode 150.

The preliminary well region 133P may have a second conductivity type that is different from the first conductivity type. The preliminary well region 133P may be lightly doped with a second conductivity type. The second conductivity type may be p-type, but is not limited thereto. The doping concentration of the preliminary well region 133P may be lower than the doping concentration of the first preliminary shield layer 310P and the doping concentration of the second preliminary shield layer 320P. The doping concentration of the preliminary well region 133P may be lower than the doping concentration of the first deep well region 161 and the doping concentration of the second deep well region 162. The doping concentration of the preliminary well region 133P may be about 1*10¹⁷cm⁻³ or more and about 1*10¹⁹cm⁻³ or less (e.g., greater than or equal to 1*10¹⁷cm⁻³ and less than or equal to 1*10¹⁹cm⁻³). The thickness of the preliminary well region 133P may be about 0.3 µm or more and about 1.1 µm or less (e.g., greater than or equal to 0.3 µm and less than or equal to 1.1 µm), but example embodiments are not limited thereto. The material, doping type, doping concentration, thickness, etc. of the preliminary well region 133P are not limited thereto and may be variously changed.

In FIGS. 21 and 22, the preliminary well region 133P is formed after the first deep well region 161 and the second deep well region 162 are formed, but this is not limited thereto. As another example, the first deep well region 161 and the second deep well region 162 may be formed after forming the preliminary well region 133P.

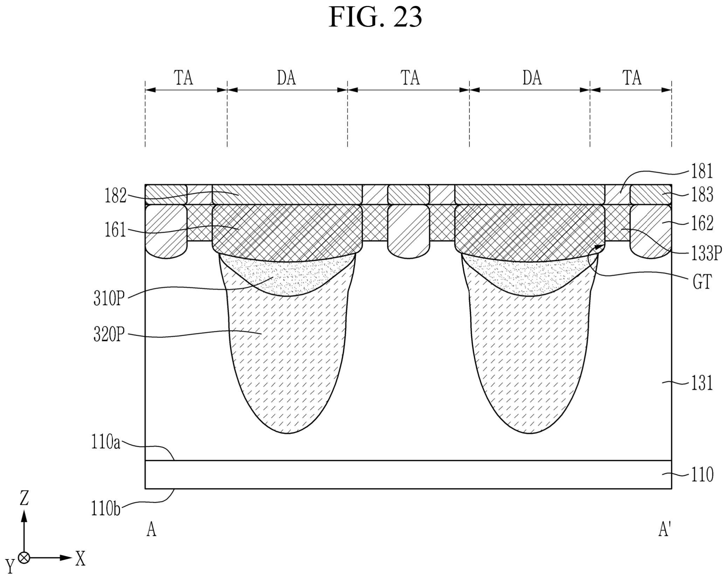

Referring to FIG. 23, a first doped layer 181 is formed, for example using an ion implantation process in the preliminary well region 133P, a second doped layer 182 is formed, for example using an ion implantation process in the first deep well region 161, and a third doped layer 183 is formed using, for example an ion implantation process in the second deep well region 162. The first doped layer 181 and the third doped layer 183 may be formed in the transistor area TA, and the second doped layer 182 may be formed in the diode area DA.

The first doped layer 181 to the third doped layer 183 may have substantially the same thickness. For example, the thickness of the first doped layer 181 along the third direction (Z direction), the thickness of the second doped layer 182 along the third direction (Z direction), and the thickness of the third doped layer 183 along the third direction (Z direction) may be substantially the same, but are not limited thereto.

The first doped layer 181 may have a first conductivity type. The first doped layer 181 may be doped with the first conductivity type. The first conductivity type may be n-type, but is not limited thereto. The doping concentration of the first doped layer 181 may be greater than the doping concentration of the epitaxial layer 131. The doping concentration of the first doped layer 181 may be about 1*10¹⁸cm⁻³ or more and about 5*10²⁰cm⁻³ or less (e.g., greater than or equal to 1*10¹⁸cm⁻³ and less than or equal to 5*1 0²⁰cm⁻³). The thickness of the first doped layer 181 may be about 0.1 µm or more and about 0.5 µm or less (e.g., greater than or equal to 0.1 µm and less than or equal to 0.5 µm). The material, doping type, doping concentration, etc. of the first doped layer 181 are not limited thereto and may be changed in various ways.

The second doped layer 182 may have a second conductivity type. The second doped layer 182 may be heavily doped with the second conductivity type. The second conductivity type may be p-type, but not limited thereto. In an embodiment, the doping concentration of the second doped layer 182 may be greater than the doping concentration of the first deep well region 161 and the doping concentration of the second deep well region 162. Additionally, the doping concentration of the second doped layer 182 may be greater than the doping concentration of the first preliminary shield layer 310P. Additionally, the doping concentration of the second doped layer 182 may be about 1*10¹⁸cm⁻³ or more and about 5*10²⁰cm⁻³ or less (e.g., greater than or equal to 1*10¹⁸cm⁻³ and less than or equal to 5*10²⁰cm⁻³). The material, doping type, doping concentration, etc. of the second doped layer 182 are not limited thereto and may be changed in various ways.

The third doped layer 183 may have a second conductivity type. The third doped layer 183 may be heavily doped with the second conductivity type. The second conductivity type may be p-type, but is not limited thereto.

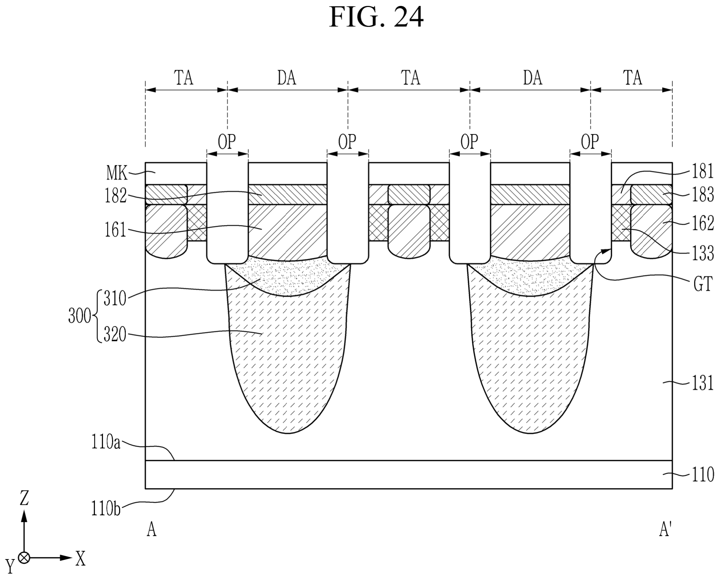

Referring to FIG. 24, a mask pattern MK having an opening OP is formed on the first doped layer 181 to the third doped layer 183, and the first doped layer 181, the second doped layer 182, the well region 133, and the first deep well region 161 are patterned using the mask pattern MK as a mask to form a gate trench GT.

The mask pattern MK may have an opening OP. The opening OP may expose the first doped layer 181 and the second doped layer 182. A gate trench GT may be formed by patterning the first doped layer 181, the second doped layer 182, the well region 133, and the first deep well region 161 exposed by the opening OP.

The gate trench GT may be formed to a predetermined depth. The depth of the gate trench GT in the third direction (Z direction) may be greater than the thickness of the well region 133 in the third direction (Z direction). The depth of the gate trench GT in the third direction (Z direction) may be greater than the thickness of the first deep well region 161 in the third direction (Z direction) and the thickness of the second deep well region 162 in the third direction (Z direction).

In this case, at least a portion of the preliminary epitaxial layer 131, at least a portion of the first preliminary shield layer 310P, and at least a portion of the second preliminary shield layer 320P may be removed together. At least a portion of the preliminary well region 133P may be removed to form a well region 133. At least a portion of the first preliminary shield layer 310P may be removed to form the first shield layer 310. At least a portion of the second preliminary shield layer 320P may be removed to form a second shield layer 320. Accordingly, a shield pattern 300 may be formed. The depth of the gate trench GT in the third direction (Z direction) may be smaller than the thickness of the shield pattern 300 in the third direction (Z direction).

As the gate trench GT is formed, the first deep well region 161 and the epitaxial layer 131 may be spaced apart in the first direction (X direction). Additionally, as the gate trench GT is formed, the first doped layer 181 and the second doped layer 182 may be spaced apart in the first direction (X direction).

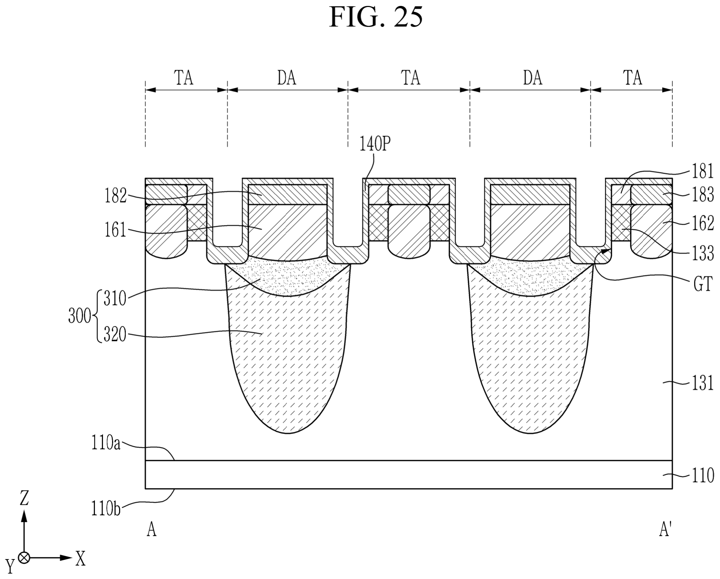

Referring to FIG. 25, after removing the mask pattern MK, a preliminary gate insulating layer 140P is formed within the gate trench GT.

A preliminary gate insulating layer 140P may be formed on the bottom surface and inner side wall of the gate trench GT. In this case, a preliminary gate insulating layer 140P may be formed on the first doped layer 181 to the third doped layer 183. In an embodiment, the preliminary gate insulating layer 140P may be positioned on the shield pattern 300 and the epitaxial layer 131. The lower surface of the preliminary gate insulating layer 140P may be in contact with the shield pattern 300 and the epitaxial layer 131. The preliminary gate insulating layer 140P may be in contact with the well region 133 and the first deep well region 161. The preliminary gate insulating layer 140P may be in contact with the first doped layer 181 and the second doped layer 182.

The process of forming a preliminary gate insulating layer 140P may be performed by repeating a deposition process for depositing a preliminary gate insulating layer material layer and an etching process for etching at least a portion of the preliminary gate insulating layer material layer several times. The deposition process for depositing the preliminary gate insulating layer material layer may be performed using an atomic layer deposition method, but example embodiments are not limited thereto. Additionally, the etching process for etching at least a portion of the preliminary gate insulating layer material layer may be performed using a wet etching method, but example embodiments are not limited thereto. For example, the preliminary gate insulating layer 140P may be formed by repeatedly forming a preliminary gate insulating layer material layer with a uniform thickness and using an etching process to remove at least a portion of the preliminary gate insulating layer material layer positioned on the side surface of the first doped layer 181, the side surface of the well region 133, the side surface of the first deep well region 161, and the side surface of the second doped layer 182 several times, but example embodiments are not limited thereto. Accordingly, the thickness of the preliminary gate insulating layer 140P perpendicular to a surface on which it is formed in the first direction (X direction) may be smaller than the thickness in the third direction (Z direction).

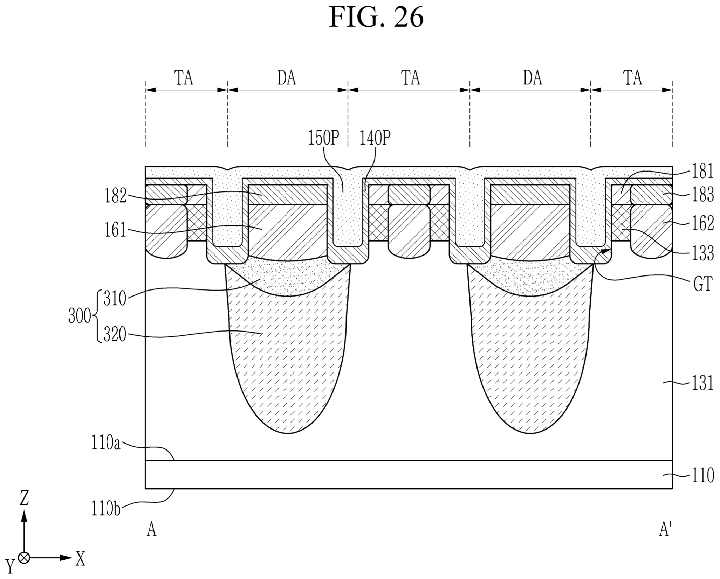

Referring to FIG. 26, a gate electrode material layer 150P is formed within a gate trench GT. The gate electrode material layer 150P may fill the gate trench GT. The gate electrode material layer 150P may include a conductive material. For example, the gate electrode material layer 150P may include polysilicon doped with impurities. As another example, the gate electrode material layer 150P may include a metal, a metal alloy, a conductive metal nitride, a metal silicide, a doped semiconductor material, a conductive metal oxide, a conductive metal nitride, or a combination thereof. The gate electrode material layer 150P may be formed of a single layer or multiple layers.

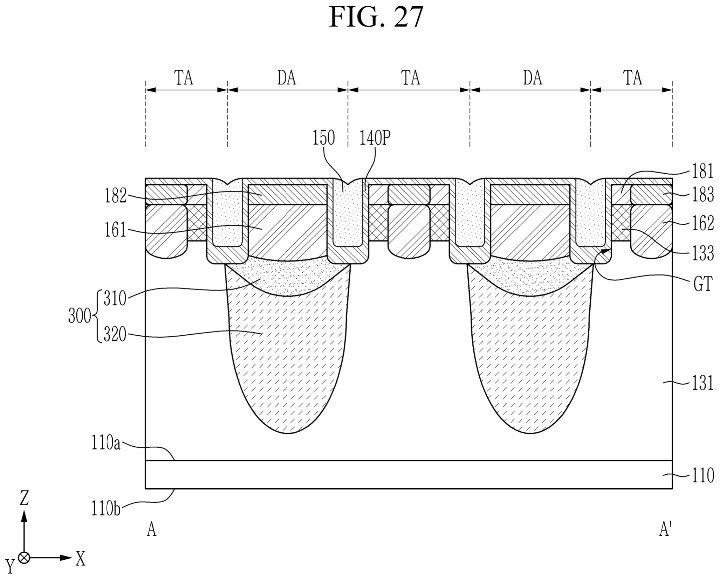

Referring to FIG. 27, a gate electrode 150 is formed by removing at least a portion of a gate electrode material layer 150P positioned on a preliminary gate insulating layer 140P (e.g., position on (e.g., above) the first to third doped regions 181 to 183 (e.g., located outside of the gate trench GT)). The process of removing at least a portion of the gate electrode material layer 150P may be performed using a dry etching method, but example embodiments are not limited thereto. The gate electrode 150 may be located within a gate trench GT.

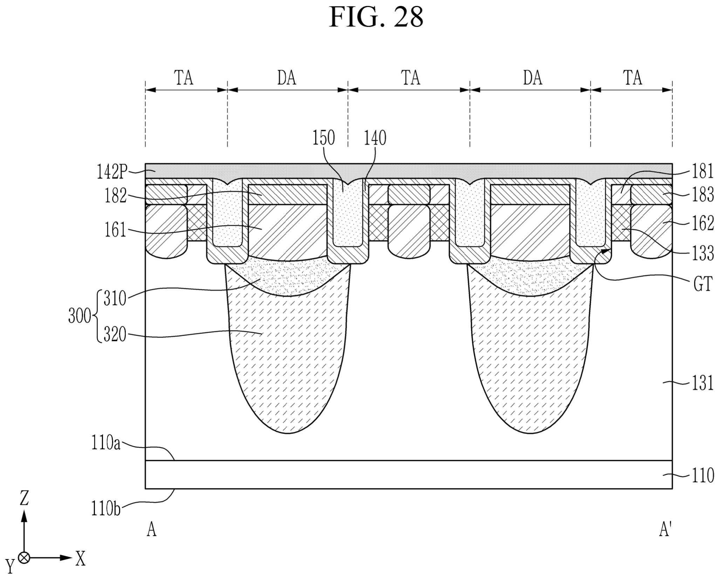

Referring to FIG. 28, a preliminary capping layer 142P is formed on the upper surface of the preliminary gate insulating layer 140P and the upper surface of the gate electrode 150. The preliminary capping layer 142P may cover the upper surface of the gate electrode 150. The preliminary capping layer 142P may cover the preliminary gate insulating layer 140P. The preliminary capping layer 142P may include an insulating material. For example, the preliminary capping layer 142P may include SiO₂, SiOP, SiN, SiON, or a combination thereof. However, example embodiments are not limited thereto, and the material of the preliminary capping layer 142P may be changed in various ways. The preliminary capping layer 142P may be formed of a single layer or multiple layers. The preliminary capping layer 142P may include the same material as the gate insulating layer 140 or may include a different material. When the preliminary capping layer 142P is made of the same material as the gate insulating layer 140, the boundary between the preliminary capping layer 142P and the gate insulating layer 140 may not be clearly distinguished at the portion where the preliminary capping layer 142P and the gate insulating layer 140 come into contact.

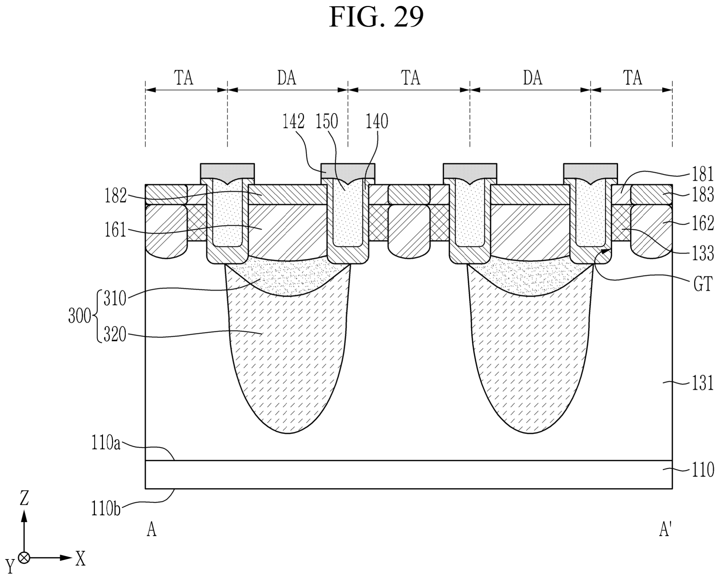

Referring to FIG. 29, a capping layer 142 and a gate insulating layer 140 may be formed by patterning a preliminary capping layer 142P and a preliminary gate insulating layer 140P. The gate insulating layer 140 may cover at least a portion of the first doped layer 181 and the second doped layer 182. One side of the capping layer 142 may be aligned with one side of the gate insulating layer 140.

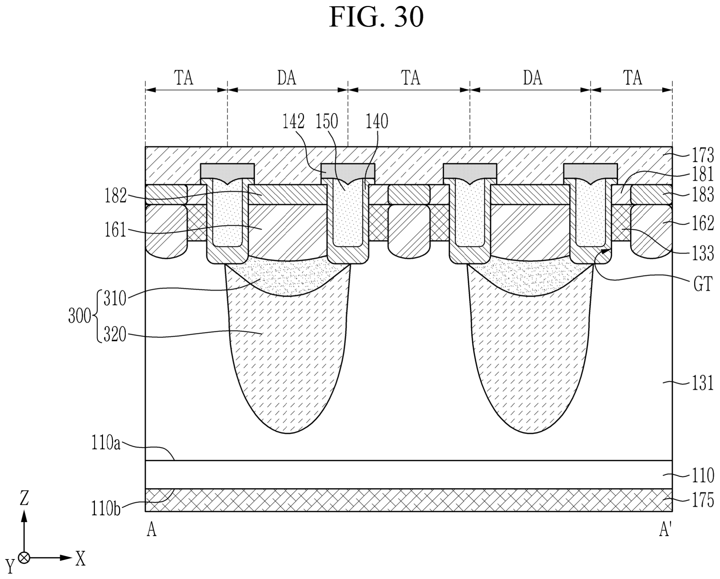

Referring to FIG. 30, a source electrode 173 is formed on the first doped layer 181 to the third doped layer 183 and the capping layer 142, and a drain electrode 175 is formed on the second surface 110b of the substrate 110, thereby forming a semiconductor device according to an embodiment.

The source electrode 173 may be in ohmic contact with the first doped layer 181 to the third doped layer 183. The source electrode 173 may include a conductive material. For example, the source electrode 173 may include a metal, a metal alloy, a conductive metal nitride, a metal silicide, a doped semiconductor material, a conductive metal oxide, or a conductive metal nitride. For example, the source electrode 173 may be formed of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbide nitride (TiAlC-N), titanium aluminum carbide (TiAIC), titanium carbide (TiC), tantalum carbide nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combinations thereof. The source electrode 173 may be formed of a single layer or multiple layers.

The drain electrode 175 may be in ohmic contact with the substrate 110. The drain electrode 175 may include a conductive material. For example, the drain electrode 175 may include a metal, a metal alloy, a conductive metal nitride, a metal silicide, a doped semiconductor material, a conductive metal oxide, or a conductive metal nitride. The drain electrode 175 may be made of the same material as the source electrode 173 or may be made of a different material. The drain electrode 175 may be formed of a single layer or multiple layers.

Hereinafter, a method for manufacturing a semiconductor device according to some embodiments will be described with reference to FIGS. 31 to 35.

FIGS. 31 to 35 are cross-sectional views corresponding to A-A' of FIG. 1, showing a method for manufacturing a semiconductor device according to the embodiments of FIGS. 14 to 16.

The embodiments illustrated in FIGS. 31 to 35 are similar to the embodiments illustrated in FIGS. 18 to 30, so a description thereof will be omitted and the differences will be mainly described. Additionally, the same drawing symbols are used for the same components as in the previous embodiment. In the embodiments of FIGS. 31 to 35, unlike the embodiments of FIGS. 18 to 30, the process of forming the first preliminary shield layer (see 310P of FIG. 20) after forming the second preliminary shield layer within the epitaxial layer 131 may be omitted.

Referring to FIG. 31, an epitaxial layer 131 is formed on a first surface 110a of a substrate 110, a second preliminary shield layer is formed within the epitaxial layer 131 using a channeling ion implantation process and/or a high energy implant process, and a first deep well region 161, a second deep well region 162, and a well region 133 may be formed within the epitaxial layer 131. Next, a first doped layer 181 may be formed within the well region 133, and a second doped layer 182 may be formed within the first deep well region 161. Next, a mask pattern MK having an opening is formed on the first doped layer 181 to the third doped layer 183, and the first doped layer 181, the second doped layer 182, the well region 133, and the first deep well region 161 are patterned using the mask pattern MK as a mask to form a gate trench GT.

The gate trench GT may be formed to a predetermined depth. The depth of the gate trench GT in the third direction (Z direction) may be greater than the thickness of the well region 133 in the third direction (Z direction). The depth of the gate trench GT in the third direction (Z direction) may be greater than the thickness of the first deep well region 161 in the third direction (Z direction) and the thickness of the second deep well region 162 in the third direction (Z direction). At least a portion of the second preliminary shield layer may be removed to form a second shield layer 320. The second shield layer 320 and the epitaxial layer 131 may be exposed by the gate trench GT. The bottom surface of the gate trench GT may be defined by the second shield layer 320 and the epitaxial layer 131. The inner side wall of the gate trench GT may be defined by a first doped layer 181, a well region 133, an epitaxial layer 131, a second doped layer 182, and a first deep well region 161.

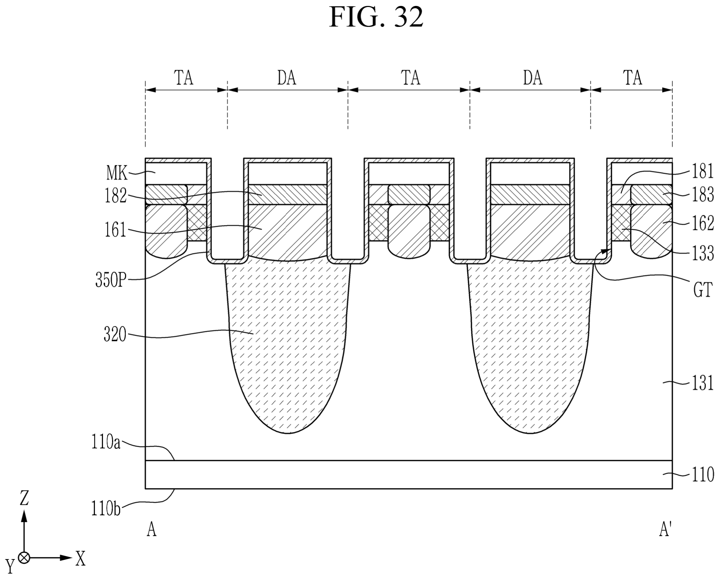

Referring to FIG. 32, a preliminary spacer 350P may be formed within a gate trench GT. For example, a preliminary spacer 350P may be formed on the upper surface of the mask pattern MK, the inner side wall and the bottom surface of the gate trench GT. The preliminary spacer 350P may be conformally formed on the upper surface of the mask pattern MK, the inner side wall and the bottom surface of the gate trench GT. A preliminary spacer 350P may be formed on the second shield layer 320 and the epitaxial layer 131 defining the bottom surface of the gate trench GT. A preliminary spacer 350P may be formed on the first doped layer 181, the well region 133, the epitaxial layer 131, the second doped layer 182, and the first deep well region 161 defining the inner side wall of the gate trench GT.

The preliminary spacer 350P may contain various insulating materials. The preliminary spacer 350P may include the same material as the gate insulating layer 140, but example embodiments are not limited thereto. For example, the preliminary spacer 350P may include SiO₂.

Referring to FIG. 33, at least a portion of the preliminary spacer 350P may be etched to form the spacer 350. The process of etching at least a portion of the preliminary spacer 350P may be performed using a dry etching method, but example embodiments are not limited thereto. A portion of the preliminary spacer 350P positioned on the bottom surface of the gate trench GT and a portion of the preliminary spacer 350P positioned on the upper surface of the mask pattern MK may be removed to form a spacer 350. Accordingly, a portion of the second shield layer 320 and a portion of the epitaxial layer 131 forming the bottom surface of the gate trench GT may be exposed. In this case, the spacer 350 may be positioned on the inner surface of the gate trench GT. The inner surface of the gate trench GT may not be exposed (e.g., may be covered) by the spacer 350.

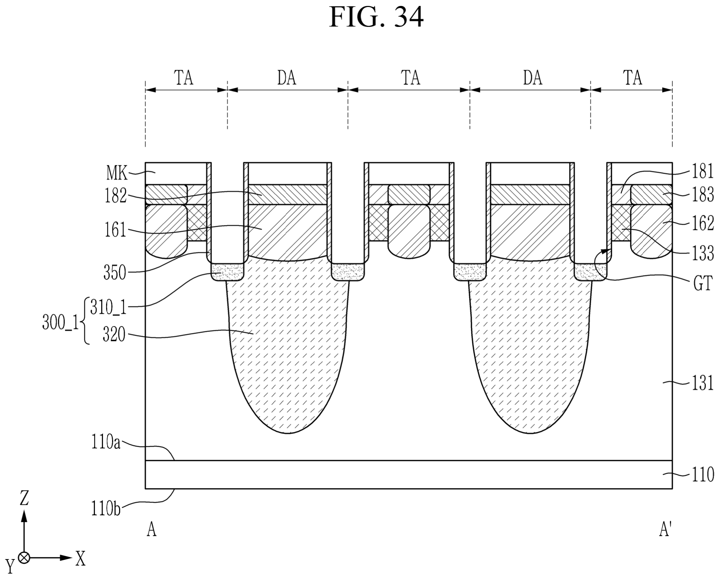

Referring to FIG. 34, a first shield layer 310_1 may be formed using a channeling ion implantation process and/or a high energy implant process within the exposed second shield layer 320 and epitaxial layer 131.

The first shield layer 310_1 may be formed under the gate trench GT. The first shield layer 310_1 may be formed between the gate trench GT and the epitaxial layer 131 and between the gate trench GT and the second shield layer 320. The first shield layer 310_1 may protrude from the bottom surface of the gate trench GT toward the first surface 110a of the substrate 110.

The first shield layer 310_1 may overlap the gate trench GT in the third direction (Z direction). For example, the entirety of the first shield layer 310_1 may overlap the gate trench GT in the third direction (Z direction), but example embodiments are not limited thereto. The first shield layer 310_1 does not overlap the first deep well region 161 and the well region 133 in the third direction (Z direction). At least a portion of the first shield layer 310_1 may overlap the second shield layer 320 in the third direction (Z direction). For example, a part of the first shield layer 310_1 may overlap the second shield layer 320 in the third direction (Z direction), and the remaining part may not overlap the second shield layer 320 in the third direction (Z direction). The lower surface of the first shield layer 310_1 may be in contact with the second shield layer 320 and the epitaxial layer 131, but example embodiments are not limited thereto.

The width of the first shield layer 310_1 along the first direction (X direction) may be smaller than the width of the gate trench GT along the first direction (X direction). This is because the first shield layer 310_1 is formed within the portion of the epitaxial layer 131 exposed by the spacer 350 and the portion of the second shield layer 320. However, example embodiments are not limited thereto, and the width of the first shield layer 310_1 along the first direction (X direction) may be greater than or equal to the width of the gate trench GT along the first direction (X direction).

Accordingly, even when the gate trench GT is formed so as not to overlap with the shield pattern 300_1 in the third direction (Z direction) due to misalignment, etc., the first shield layer 310_1 may be formed under the gate trench GT. Accordingly, the shield pattern 300 may prevent the breakdown voltage of the transistor from decreasing due to an electric field generated by a voltage applied to the gate electrode 150, and may improve the reliability of the semiconductor device according to the embodiment.

Since the inner side wall of the gate trench GT is not exposed by the spacer 350, the components comprising the inner side wall of the gate trench GT may not be doped. For example, in the process of forming the second shield layer 320, ions may not be injected into the well region 133 due to the spacer 350.

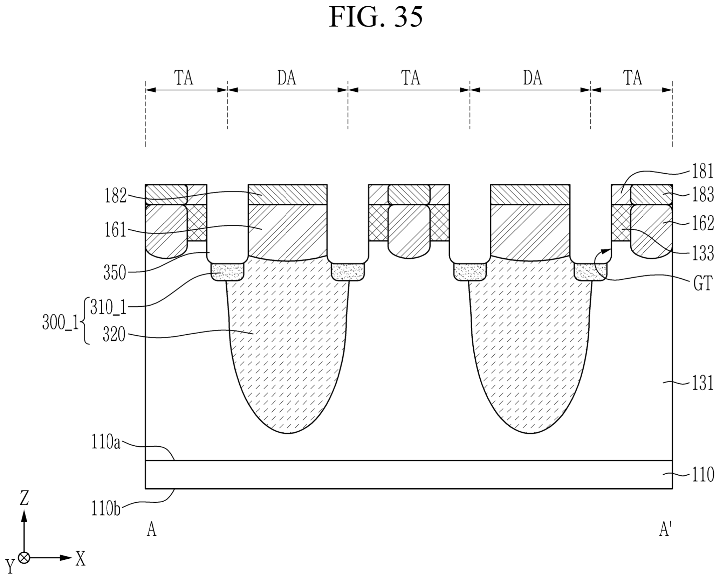

Referring to FIG. 35, the spacer 350 and the mask pattern MK may be removed. In this case, at least a portion of the spacer 350 located within the gate trench GT may remain without being removed to form a dummy pattern (see 355 of FIG. 16) of the embodiment of FIG. 16. The dummy pattern (see 355 in FIG. 16) may be a pattern in which at least a portion of the spacer 350 is not removed during the process of removing the spacer 350 located within the gate trench GT.

Next, a gate insulating layer 140 may be formed on the bottom surface and inner side wall of the gate trench GT, and a gate electrode 150 may be formed within the gate trench GT. Next, a capping layer 142 may be formed on the gate electrode 150, a source electrode 173 may be formed on the first doped layer 181 to the third doped layer 183 and the capping layer 142, and a drain electrode 175 may be formed on the second surface 110b of the substrate 110, thereby forming a semiconductor device according to the embodiments of FIGS. 14 to 16.

Embodiments described herein include "deep" well regions (e.g., a first deep well region 161 and a second deep well region 162). The term "deep" in this context may refer to depth relative to the well region 133. For instance, the first deep region 161 may be deeper than the well region 133. For instance, the lower surface of the first deep well region 161 may be lower than (e.g., closer to the substrate 110 than) the lower surface of the well region 133. For instance, the second deep region 162 may be deeper than the well region 133. For instance, the lower surface of the second deep well region 162 may be lower than (e.g., closer to the substrate 110 than) the lower surface of the well region 133. The well region 133, the first deep well region 161 and the second deep well region 162 may be otherwise known as a first well region 133, a second well region 161 and a third well region 162, respectively.

Embodiments are set out in the following Clauses:
Clause 1. A semiconductor device comprising:
   a substrate including a first surface and a second surface opposing each other;
   an epitaxial layer positioned on the first surface of the substrate, including a gate trench, and having a first conductivity type;
   a gate electrode positioned within the gate trench;
   a gate insulating layer positioned between the epitaxial layer and the gate electrode;
   a source electrode positioned on the epitaxial layer;
   a well region positioned on a first side of the gate electrode, between the epitaxial layer and the source electrode, the well region having a second conductivity type, different from the first conductivity type;
   a first deep well region positioned on a second side of the gate electrode opposite the first side, and between the epitaxial layer and the source electrode, the first deep well region having the second conductivity type;
   a second deep well region positioned between the epitaxial layer and the source electrode, located on a first side of the well region, the second deep well region having the second conductivity type;
   a first doped layer positioned between the well region and the source electrode, the first doped layer having the first conductivity type;
   a second doped layer positioned between the first deep well region and the source electrode, the second doped layer having the second conductivity type;
   a third doped layer positioned between the second deep well region and the source electrode;
   a shield pattern positioned between the epitaxial layer and the first deep well region, the shield pattern having the second conductivity type; and
   a drain electrode positioned on the second surface of the substrate;
   wherein a width of the shield pattern is greater than or equal to a width of the first deep well region, and
   the shield pattern has a doping concentration greater than or equal to a doping concentration of the first deep well region.
Clause 2. The semiconductor device of Clause 1,
   wherein the doping concentration of the first deep well region and a doping concentration of the second deep well region are greater than a doping concentration of the well region.
Clause 3. The semiconductor device of Clause 1 or Clause 2,
   wherein a distance between a lower surface of the first deep well region and the first surface of the substrate is smaller than a distance between a lower surface of the well region and the first surface of the substrate.
Clause 4. The semiconductor device of any of Clauses 1-3,
   wherein the shield pattern overlaps the gate electrode and does not overlap the well region.
Clause 5. A semiconductor device comprising:
   a substrate including an active area where a plurality of cells are positioned and a peripheral area surrounding at least a portion of the active area; and
   a gate frame positioned in the peripheral area, including a first portion and a second portion, the first portion and the second portion extending in a first direction and arranged spaced apart in a second direction intersecting the first direction,
   wherein the plurality of cells are positioned between the first portion and the second portion of the gate frame,
   wherein each of the plurality of cells includes:
      an epitaxial layer including a gate trench positioned on a first surface of the substrate and extending in the second direction, the epitaxial layer having a first conductivity type;
      a gate electrode positioned within the gate trench and electrically connected to the gate frame;
      a gate insulating layer positioned between the epitaxial layer and the gate electrode;
      a source electrode positioned on the epitaxial layer;
      a well region positioned on a first side of the gate electrode along the first direction, and positioned between the epitaxial layer and the source electrode, the well region having a second conductivity type different from the first conductivity type;
      a first deep well region positioned on a second side of the gate electrode opposite the first side along the first direction, and positioned between the epitaxial layer and the source electrode, the first deep well region having the second conductivity type;
      a shield pattern positioned between the epitaxial layer and the first deep well region, extending in the second direction, and overlapping the gate electrode; and
      a drain electrode positioned on a second surface of the substrate opposite the first surface,
      wherein a lower surface of the shield pattern includes a convex curved surface that is convex toward the drain electrode.

Although the embodiments have been described in detail above, the scope of the present invention is not limited thereto, and various modifications and improvements made by those skilled in the art using the basic concept of the present invention defined in the following claims also fall within the scope of the present invention.

## Claims

1. A semiconductor device comprising:
a substrate (110) including a first surface and a second surface opposing each other;
an epitaxial layer (131) positioned on the first surface of the substrate and including a gate trench (GT), the epitaxial layer (131) having a first conductivity type;
a gate electrode (150) positioned within the gate trench (GT);
a gate insulating layer (140) positioned between the epitaxial layer (131) and the gate electrode (150);
a source electrode (173) positioned on the epitaxial layer (131);
a well region (133) positioned on a first side of the gate electrode (150), between the epitaxial layer (131) and the source electrode (173), the well region (133) having a second conductivity type different from the first conductivity type;
a first deep well region (161) positioned on a second side of the gate electrode (150) opposite the first side, between the epitaxial layer (131) and the source electrode (173), the first deep well region (161) having the second conductivity type and extending below the source electrode (173) a greater distance than the well region (133);
a shield pattern (300) positioned between the epitaxial layer (131) and the first deep well region (161), the shield pattern (300) overlapping the gate electrode (150); and
a drain electrode (175) positioned on the second surface of the substrate (110);
wherein a lower surface of the shield pattern (300) includes a convex curved surface that is convex toward the drain electrode (175).

2. The semiconductor device of claim 1,
wherein the first deep well region (161) has a greater doping concentration than a doping concentration of the well region (133).

3. The semiconductor device of claim 1 or claim 2,
wherein the maximum thickness of the first deep well region (161) in a vertical direction is greater than the maximum thickness of the well region (133) in the vertical direction.

4. The semiconductor device of any preceding claim,
wherein the shield pattern (300) has the second conductivity type, and
the shield pattern (300) has a doping concentration greater than or equal to the doping concentration of the first deep well region (161).

5. The semiconductor device of any preceding claim,
wherein the shield pattern (300) has a thickness in a vertical direction greater than a thickness of the well region (133) in the vertical direction, and
the shield pattern (300) has a thickness in the vertical direction less than a distance between the first deep well region (161) and the drain electrode (175).

6. The semiconductor device of any preceding claim,
wherein the shield pattern (300) is in contact with a lower surface of the gate insulating layer (140) and a lower surface of the first deep well region (161).

7. The semiconductor device of any preceding claim,
wherein the shield pattern (300) includes:
a first shield layer (310) positioned on a lower surface of the gate insulating layer (140) and a lower surface of the first deep well region (161), the first shield layer (310) having the second conductivity type, and
a second shield layer (320) positioned between the first shield layer (310) and the epitaxial layer (131), the second shield layer (320) having the second conductivity type;
wherein a lower surface of the second shield layer (320) includes a convex curved surface that is convex toward the drain electrode (175).

8. The semiconductor device of claim 7,
wherein a lower surface of the first shield layer (310) includes a convex curved surface that is convex toward the drain electrode (175), and
a curvature of the lower surface of the second shield layer (320) is greater than a curvature of the lower surface of the first shield layer (310).

9. The semiconductor device of claim 7 or claim 8,
wherein the first shield layer (310) is in contact with at least a portion of a side surface of the gate insulating layer (140).

10. The semiconductor device of any of claims 7-9,
wherein at least a portion of the first shield layer (310) overlaps the gate electrode (150) in a horizontal direction.

11. The semiconductor device of any of claims 7-10,
wherein an edge of the first shield layer (310) is aligned with a side surface of the gate insulating layer (140).

12. The semiconductor device of any of claims 7-11,
wherein a width of the first shield layer (310) is greater than a width of the first deep well region (161).

13. The semiconductor device of any preceding claim,
wherein the gate insulating layer (140) includes:
a vertical portion positioned between the well region (133) and the gate electrode (150) and between the first deep well region (161) and the gate electrode (150) and having a first thickness in a first direction parallel to the first surface of the substrate (110), and
a horizontal portion positioned between the shield pattern (300) and the gate electrode (150) and having a second thickness in a second direction perpendicular to the first surface of the substrate (110),
wherein the first thickness is less than the second thickness.

14. The semiconductor device of any preceding claim, further comprising:
a first doped layer (181) located between the well region (133) and the source electrode (173), the first doped layer (181) having the first conductivity type; and
a second doped layer (182) positioned between the first deep well region (161) and the source electrode (173), the second doped layer (182) having the second conductivity type.

15. The semiconductor device of claim 14, further comprising:
a second deep well region (162) positioned between the epitaxial layer (131) and the source electrode (173), the second deep well region (162) having the second conductivity type, and
a third doped layer (183) positioned between the second deep well region (162) and the source electrode (173),
wherein the well region (133) is positioned between the gate insulating layer (140) and the second deep well region (162).
